(19)

Europäisches
Patentamt
European
Patent Office
Office européen
des brevets

(11) **EP 1 967 996 A1**

(12) **EUROPEAN PATENT APPLICATION**

(43) Date of publication:
**10.09.2008 Bulletin 2008/37**

(51) Int Cl.:
***G06Q 10/00*** *(2006.01)*

(21) Application number: **08152399.5**

(22) Date of filing: **06.03.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **09.03.2007 JP 2007061043
19.10.2007 JP 2007273107**

(71) Applicant: **Omron Corporation
Kyoto-shi, Kyoto 600-8530 (JP)**

(72) Inventors:
 • **Tasaki, Hiroshi**
 **c/o Omron Corporation
 Shimogyo-ku, Kyoto-shi
 Kyoto Kyoto 600-8530 (JP)**

 • **Hasegawa, Yoshifumi**
 **c/o Omron Corporation
 Shimogyo-ku, Kyoto-shi
 Kyoto Kyoto 600-8530 (JP)**
 • **Ohtani, Satoshi**
 **c/o Omron Corporation
 Shimogyo-ku, Kyoto-shi
 Kyoto Kyoto 600-8530 (JP)**
 • **Kawai, Takuma**
 **c/o Omron Corporation
 Shimogyo-ku, Kyoto-shi
 Kyoto Kyoto 600-8530 (JP)**
 • **Kojitani, Kazuto**
 **c/o Omron Corporation
 Shimogyo-ku, Kyoto-shi
 Kyoto Kyoto 600-8530 (JP)**

(74) Representative: **Brykman, Georges
 Osha Liang
 121, Avenue des Champs Élysées
 75008 Paris (FR)**

(54) **Factor estimating support device and method of controlling the same, and factor estimating support program**

(57)   A factor estimating support device (10) supports estimation of factor from a result generated in a production system. In the factor estimating support device (10), material/environment history data (40) and test history data (41) acquired from the production system, and the causality structure data (42) indicating causality between the plurality of variables are stored in the storage unit (21), where when determined that the final quality char- acteristic is abnormal in the final quality abnormal detecting part (32), determination is made on whether each variable other than the final quality characteristic is abnormal in the variable abnormality detecting part (33), and the determination result is reflected on a visible image in which the causality structure data (42) is visualized in the visible image creating part (34).

**Description**

BACKGROUND OF THE INVENTION

1. Technical Field

The present invention relates to a factor estimating support device to support estimation of a factor from the result generated in a system to be diagnosed and a method of controlling the same, as well as a factor estimating support program. The present invention, for example, relates to a factor estimating support device etc. to support estimation of causes from abnormality generated in a production system for manufacturing products through a plurality of steps.

2. RELATED ART

An improvement process of the step is required in the production line of a factory to enhance yield. Such improvement process of the step first specifies the step, which is the factor of fault of the manufactured article, and performs adjustment, cleaning, and the like of the equipment to remove such factor.
However, in a manufacturing step including a plurality of steps, various factors are assumed as candidates for the factor of fault such as defect in the parts of the manufacturing device, problem in setting of the manufacturing device, problem in conveyance path, and the like. For instance, the step of a surface mounting system of a circuit substrate is divided into printing step - mounting step - reflow step. A solder paste is printed on the substrate in the printing step, and a part is attached onto the substrate in the mounting step. In the final reflow step, heat is applied to melt the solder and adhere the part. When bridge fault occurs in such surface mounting system, a great number of factors that causes the bridge fault can be assumed such as mask misalignment, tainted lower die, and the like, but one or a plurality of such factors is the primary cause.
A technique of automatically estimating the primary factor from various factors using the intensity of causality is disclosed in Japanese Patent Application Laid-Open No. 2006-065598 (published March 9, 2006), and Japanese Patent Application Laid-Open No. 2006-173373 (published June 29, 2006). However, the factor with the strongest causality is not necessarily the primary factor. Since the primary cause is automatically estimated, the process of estimating is in a black box and is not presented to the user. As a result, the persuasiveness on the estimated primary factor becomes weak.
When humans estimate the primary factor from various factors, it is difficult to perform analysis on the generation of faults since the data related to the condition of the defective article and data related to the operation history of the manufacturing device and the test history of the test device are enormous.
Since the person in charge of production management having broad experience in production management knows through experience the relationship of the influence of the fault factor on the defective product, the manufacturing device, and the test device, and the manner of interpreting such influence, the step improvement can be efficiently performed. However, those in charge of production management having little experience need to investigate the factors one at a time to specify the factor, and thus a great amount of time must be put in to the improvement process of the step.
Therefore, a method enabling every person in charge of production management of any level of skill to easily estimate the abnormality factor at the production site is desired. The present invention is provided in view of the above problems, and it is an object of the present invention to provide a factor estimating support device etc. capable of easily realizing the estimating of the abnormality factor.

SUMMARY

In accordance with one aspect of the present invention, in order to solve the above problems, a factor estimating support device according to the present invention relates to a factor estimating support device for supporting estimation of factor from a result generated in a system to be diagnosed; the factor estimating support device including a variable history storage unit for storing history information of a plurality of variables acquired from the system; a causality storage unit for storing causality information indicating a causality between the plurality of variables; a result abnormality determining part for determining whether a variable corresponding to the result is abnormal; a variable abnormality determining part for determining whether each variable other than the variable corresponding to the result is abnormal when the result abnormality determining part determines as abnormal; and a visible image creating part for creating a visible image in which the causality is visualized using the causality information, the visible image creating part adding information notifying abnormality with respect to a variable determined as abnormal by the result abnormality determining part and the variable abnormality determining part in the visible image.
In accordance with another aspect of the present invention, in order to solve the above problems, a method of controlling a factor estimating support device according to the present invention relates to a method of controlling a factor estimating support device for supporting estimation of factor from a result generated in a system to be diagnosed; the factor estimating support device including a variable history storage unit for storing history information of a plurality of variables acquired from the system, and a causality storage unit for storing causality information indicating a causality between the plurality of variables; the method including a result abnormality determining step for determining whether a variable corresponding to the result is abnormal; a variable abnormality determining step for determining whether each variable other than the variable corresponding to the result is abnormal when determined abnormal in the result abnormality determining step; and a visible image creating step for creating a visible image in which the causality is visualized using the causality information, the visible image creating step adding information notifying abnormality with respect to a variable determined as abnormal in the result abnormality determining step and the variable abnormality determining step in the visible image.

Here, normal refers to a case of satisfying a predetermined condition, and abnormal refers to a case of not satisfying a predetermined condition. Examples of information notifying abnormality include color and character that draws attention of the user such as red and character string such as "abnormal", and a pattern that highlights the relevant location such as underline and diagonal line.

In the manufacturing step, the product is a defective product when the manufactured product is tested and does not meet a predetermined standard. Thus, a reference for determining abnormality is normally provided in advance for the variable corresponding to the result, but a reference for determining abnormality is rarely provided in advance for other variables.

The influence on variation on the result is assumed to be high for variables having high causality. In the factor estimating support device according to the present invention, preferably, a causal intensity calculating means for calculating the causal intensity indicating the intensity of the causality based on the history information is further arranged, where the visible image creating means changes the causality information in the visible image based on the causal intensity.

Generally, the possibility of becoming the cause of abnormality is assumed to be high for variables having large degree of abnormality. Thus, in the factor estimating support device according to the present invention, desirably, the variable abnormality determining means calculates the degree of abnormality regarding the variable determined as abnormal, and the visible image creating means changes the causality information in the visible image based on the degree of abnormality.

In the factor estimating support device according to the present invention, desirably, the plurality of variables are categorized into a plurality of types, and the visible image created by the visible image creating means is divided into a plurality of regions each corresponding to the plurality of types, the information of the variable being arranged in the region corresponding to the type the variable belongs.

The system to be diagnosed may be a production system for manufacturing a product through a plurality of steps. In this case, when abnormality of the product, that is, a defective product is produced, the abnormality of various variables in the production system is desirably determined and reflected on the visible image in which the causality is visualized.

The system to be diagnosed may be a power supply system for supplying power to a plurality of electrical equipments, where the plurality of variables include a power consumption amount of the plurality of electrical equipments, the variable corresponding to the result is a total value of the power consumption amount in the power supply system, and the abnormality is a waste state in which the power consumption amount is greater than a reference electric energy.

DETAILED DESCRIPTION OF THE DRAWINGS

FIG. 1 shows a block diagram of a schematic configuration of a factor estimating support device in a substrate mounting system according to one embodiment of the present invention;
FIG. 2 shows a block diagram of a schematic configuration of the substrate mounting system;
FIG. 3 shows a view of one example of causality information of the substrate mounting system in a directed graph;
FIG. 4 shows a view of history information of a variable corresponding to each vertex in the causality information in a table form;
FIG. 5 shows a view with the causal intensity between the vertices written near the arrow of the causality information shown in FIG. 3;
FIG. 6 shows a graph of one example of a probability distribution of the variables corresponding to the vertices;
FIG. 7 shows one example of a visible image of the causality created based on the causality information;
FIG. 8 shows a view in which the vertex of the variable from which abnormality is detected is changed in the visible image;
FIG. 9 shows one example of material/environment history data and test history data stored in a storage unit of the factor estimating support device in a table form;

FIG. 10 shows one example of causality structure data stored in the storage unit in a directed graph;

FIG. 11 shows the causality structure data in a table form;

FIG. 12 shows one example of the variable control criterion data stored in the storage unit in a table form;

FIG. 13 shows a graph of the control criterion when the target fault rate of a certain variable is 0.01%;

FIG. 14 shows another example of the causality information in a directed graph;

FIG. 15 shows one example of a visible image created by the visible image creating part in the control unit of the factor estimating support device;

FIG. 16 shows a flowchart of an outline of the processing operation of the causal intensity calculating part and the variable control criterion setting part in the control unit;

FIG. 17 shows a flowchart of an outline of the processing operation of the final quality abnormality detecting part, the variable abnormality detecting part, and the visible image creating part of the control unit;

FIG. 18 shows a flowchart of a specific example of a process in the visible image creating part;

FIGS. 19A to 19C show views of change in the visible image as a result of performing the process;

FIG. 20 shows a flowchart of another specific example of a process in the visible image creating part;

FIGS. 21A to 21C show views of change in the visible image as a result of performing the process;

FIG. 22 shows a flowchart of another specific example of the process in the visible image creating part;

FIGS. 23A to 23C show views of change in an abnormality notifying image as a result of performing the process;

FIG. 24 shows a block diagram of a schematic configuration of a power supply system according to one example of another embodiment of the present invention;

FIG. 25 shows a block diagram of a schematic configuration of a factor estimating support device in the power supply system;

FIG. 26 shows a view of one example of setting/environment history data and electric energy history data stored in the storage unit of the factor estimating support device in a table form;

FIG. 27 shows a view of one example of causal structure data stored in the storage unit in a directed graph;

FIG. 28 shows a view of the causal structure data in a table form;

FIG. 29 shows a view of one example of a graph displayed on the display unit of the factor estimating support device;

FIG. 30 shows a view of another example of a graph displayed on the display unit;

FIG. 31A to 31C show a view of another example of a graph displayed on the display unit;

FIG. 32 shows a flowchart of an outline of a processing operation of the total electric energy waste detecting part, the individual electric energy waste detecting part, and the visible image creating part in the control unit of the factor estimating support device; and

FIG. 33 shows a flowchart of an outline of a processing operation of a predicting part in the control part.

## DETAILED DESCRIPTION

[First embodiment]

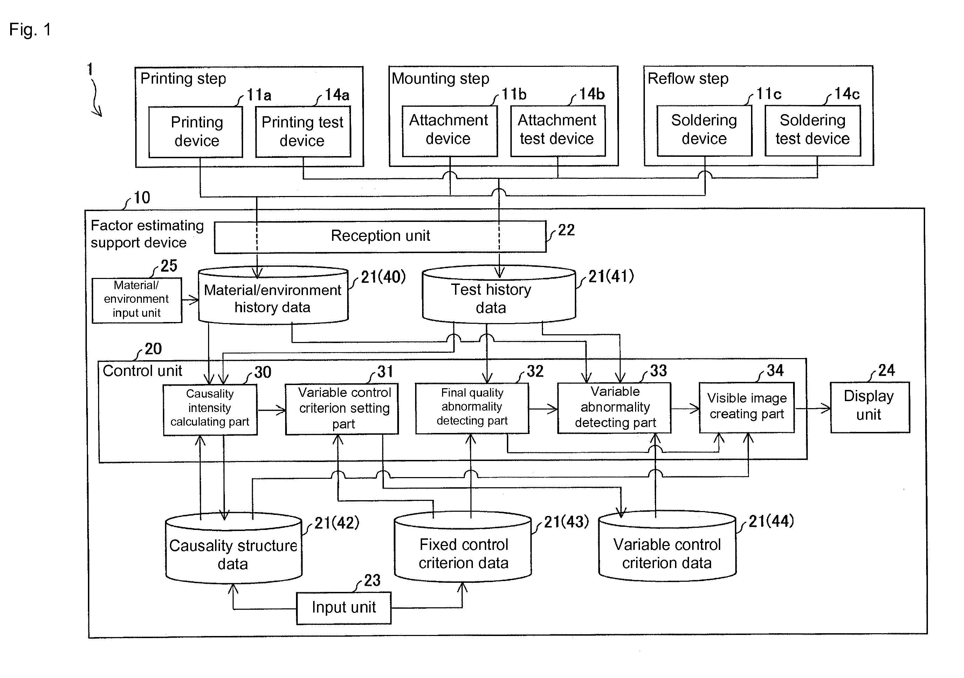

One embodiment of the present invention will be described with reference to FIGS. 1 to 23. The present invention is applied to a surface mounting system including a production line for mounting electronic parts on a print substrate in the present embodiment, but the present invention is not limited to the mounting system of the print substrate, and can be applied to the whole management of the processing step of the subject. The processing step of the subject includes production step of engineering products, testing step of industrial products, agricultural products or ingredients, processing step of waste objects (e.g., industrial waste, industrial waste water, waste gas, garbage, etc.), testing step of waste objects, testing step of facilities, recycling step, and the like.

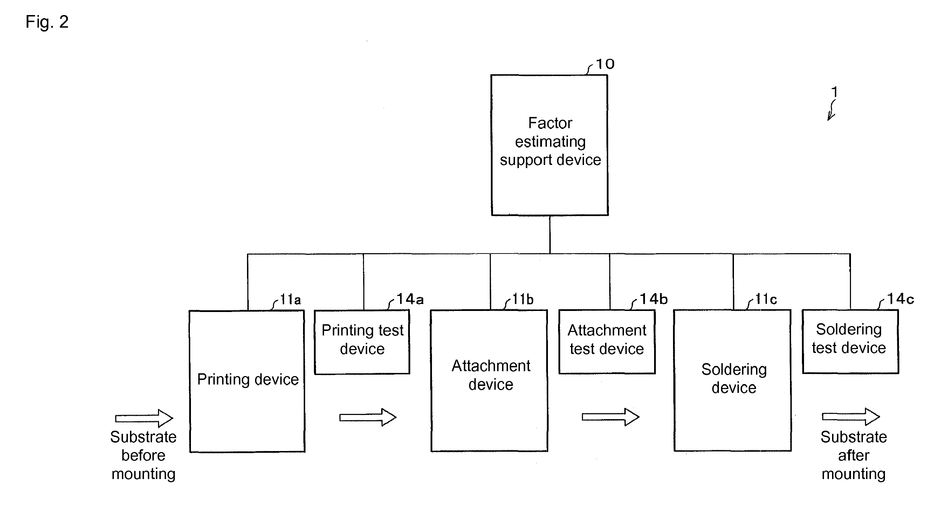

FIG. 2 shows a schematic configuration of a substrate mounting system 1 of the present embodiment. The production line in the substrate mounting system 1 includes various steps (printing step, mounting step, reflow step, etc.) for mounting the electronic part onto the print substrate.

In the example shown in FIG. 2, the substrate mounting system 1 includes a printing device 11a for performing the printing step of printing a solder paste on the substrate, an attachment device 11b for performing the mounting step of attaching the electronic part on the substrate, and a soldering device 11c for performing the reflow step of soldering the electronic part on the substrate. The printing device 11a, the attachment device 11 b, and the soldering device 11c are arranged in this order from the upstream to the downstream in the flow of manufactured articles of the substrate mounting system 1. If the printing device 11a, the attachment device 11b, and the soldering device 11c do not need to be distinguished from one another, the devices are simply referred hereinafter to as processing device 11.

A printing test device 14a is arranged in the vicinity of the printing device 11a, an attachment test device 14b is arranged in the vicinity of the attachment device 11b, and a soldering test device 14c is arranged in the vicinity of the soldering device 11c. The printing test device 14a tests the quality of the substrate processed in the printing device 11a.

The attachment test device 14b tests the substrate processed in the attachment device 11b. The soldering test device 14c tests the substrate processed in the soldering device 11c. Furthermore, the soldering test device 14c tests the final quality characteristics of the product manufactured in the substrate mounting system 1 as it is positioned at the most downstream part of the production line. If the printing test device 14a, the attachment test device 14b, and the soldering test device 14c do not need to be distinguished from one another, the devices are simply referred hereinafter to as test device 14.

In the present embodiment, the substrate mounting system 1 includes a factor estimating support device 10 for supporting the user to estimate the factor of the fault when the soldering test device 14c determines the fault of the product. The factor estimating support device 10, the printing device 11a, the attachment device 11b, the soldering device 11c, the printing test device 14a, the attachment test device 14b, and the soldering test device 14c form a communication network by being connected to each other through communication lines. The communication network may take any form as long as each device is communicable with each other, and may take a form of a LAN (Local Area Network).

In the above example, the test device 14 is arranged in correspondence to each of the printing device 11a, the attachment device 11b, and the soldering device 11c, but some of the test device 14 other than the test device 14c that performs the final test may be omitted.

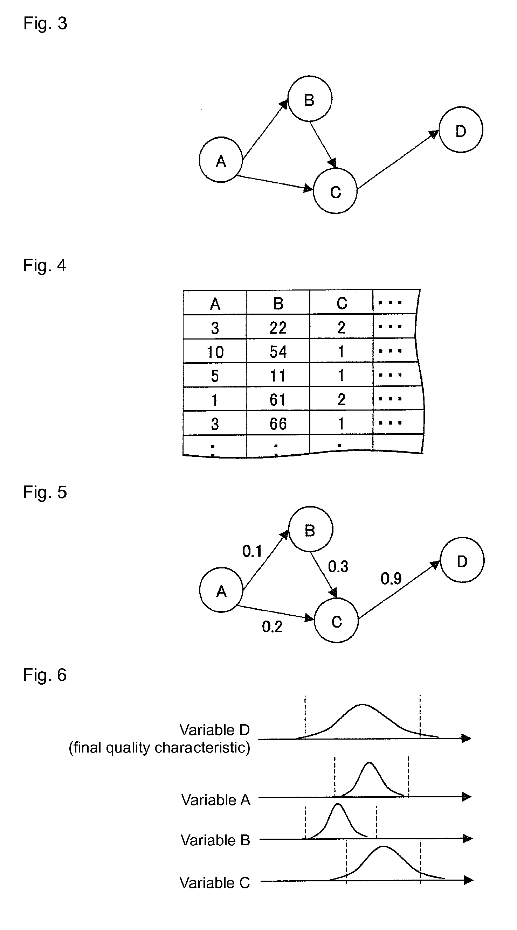

The outline of the factor estimating support device 10 will now be described with reference to FIGS. 3 to 8. The factor estimating support device 10 stores history information of a plurality of variables acquired from the substrate mounting system 1 and causality information indicating the causality between the plurality of variables.

FIG. 3 shows one example of causality information in a form of a directed graph. The directed graph shown in the figure includes vertices and arrows. The vertices A to D correspond to variables, where the vertices connected with an arrow has causality. The direction of the arrow indicates the order relationship between the vertices. Therefore, the causality information shown indicates that vertex A influences vertex B and vertex C, vertex B influences vertex C, and vertex C influences vertex D. FIG. 4 shows the history information of the variable corresponding to each vertex for every substrate that is manufactured.

The factor estimating support device 10 quantitatively evaluates the intensity of causality between the variables based on the causality information shown in FIG. 3 and the history information of the variable shown in FIG. 4. The quantitatively evaluated intensity of causality is hereinafter referred to as "causal intensity".

The causal intensity is calculated in the following manner. That is, the causality information shown in FIG. 3 is expressed by the following linear structural equation. Here, $\times$ represents that in which an average value of the history information is subtracted and normalization of dividing the standard deviance of the history information is performed with respect to the history information of the variable corresponding to each vertex. Furthermore, $\alpha$ represents causal intensity between vertices, and $\varepsilon$ represents error of each vertex.

Equation 1

$$x_B = \alpha_{BA} x_A + \varepsilon_B$$
$$x_C = \alpha_{CA} x_A + \alpha_{CB} x_B + \varepsilon_C \qquad \cdots (1)$$
$$x_D = \alpha_{DC} x_C + \varepsilon_D$$

Regression analysis is performed on equation (1) using the history information shown in FIG. 4 to calculate the causal intensity $\alpha$ between the vertices. The factor estimating support device 10 stores the calculated causal intensity $\alpha$ between the vertices with causality information.

FIG. 5 shows the calculated causal intensity $\alpha$ between the vertexes near the arrow of the causality information shown in FIG. 3. Thus, when the causality between the variables and the intensity thereof become clear, if the variable corresponding to a certain vertex fluctuates, how much the variable corresponding to the vertex of the posterity of the relevant vertex fluctuates can be predicted. If the variable corresponding to a certain vertex fluctuates, the variable corresponding to a vertex different from the relevant vertex is changed to suppress the fluctuation of the variable corresponding to the vertex of the posterity of the vertices.

For instance, suppose the variables corresponding to the vertices A to D correspond to the humidity of the printing device 11 a, the viscosity of the solder, the printing area of the solder, and the fillet length of the solder. In this case, if the printing area (vertex C) increases by 0.1 mm$^2$, the fillet length (vertex D) becomes longer by 0.9 mm. If the humidity (vertex A) increases by 20%, the viscosity of the solder (vertex B) is lowered by about 0.1 Pa·S to maintain the printing area (vertex C) at 0.1 mm$^2$.

The factor estimating support device 10 stores control criterion of the final quality characteristic of the product manufactured in the substrate mounting system 1. The control criterion is hereinafter referred to as "fixed control criterion" as it is defined beforehand from the design specification of the product. The factor estimating support device 10 sets the control criterion in each variable based on the calculated causal intensity between the variables and the information of the fixed control criterion. This control criterion is hereinafter referred to as "variable control criterion" as it changes according to the causal intensity. The factor estimating support device 10 stores information on the variable control criterion set for every variable.

The factor estimating support device 10 uses the history information of the variable and the information of the fixed control criterion to detect whether or not the final quality characteristic of the product is abnormal. Specifically, the sample variance $\sigma^\wedge$ (described as $\sigma$ with a hat for the sake of convenience) is calculated from the history information of the final quality characteristic (variable of vertex D). Then, a process capability index $C_p$ is calculated with the following equation using the calculated sample variance $\sigma^\wedge$, and an upper limit value $S_U$ and a lower limit value $S_L$ of the fixed control criterion.

$$C_p = (S_U - S_L)/6\sigma^\wedge \quad \cdots \quad (2)$$

The factor estimating support device 10 determines the final quality characteristic as normal if the calculated process capability index $C_p$ is greater than or equal to one, and determines the final quality characteristic as abnormal if less than one.

When detecting the abnormality of the final quality characteristic, the factor estimating support device 10 detects whether variables other than the final quality characteristic are abnormal using the history information of the variable and the information of the variable control criterion. Specifically, process similar to the process of detecting abnormality of the final quality characteristic is performed on each variable (vertex A to C) other than the final quality characteristic. That is, with respect to each variable, the sample variance $\sigma^\wedge$ is calculated from the history information, and the process capability index $C_p$ is calculated with equation (2) using the calculated sample variance $\sigma^\wedge$, and the upper limit value $S_U$ and the lower limit value $S_L$ of the variable control criterion. The variable is determined as normal if the calculated process capability index $C_p$ is greater than or equal to one, and determined as abnormal if less than one.

FIG. 6 shows one example of a probability distribution of the variables A to D corresponding to the vertices A to D. The broken line in the figure shows the lower limit and the upper limit of the control criterion (fixed control criterion or variable control criterion) in order from the left. In the illustrated example, the probability distribution of variable D (final quality characteristic) and variable C has large amount existing other than from the lower limit to the upper limit of the control criterion, and the process capability index $C_p$ is less than one. The probability distribution of variable A and variable B barely has any amount existing other than from the lower limit to the upper limit of the control criterion, and the process capability index $C_p$ is greater than or equal to one.

The factor estimating support device 10 examines whether or not the final quality characteristic is abnormal, and after determining that the final quality characteristic is abnormal, examines whether or not the variables A to C are abnormal, and determines that variable C is abnormal.

Furthermore, when detecting the abnormality of the final quality characteristic, the factor estimating support device 10 creates a visible image of the causality based on the causality information, and adds information such as color, character, and pattern indicating abnormality to the variable from which abnormality is detected of the variables contained in the created visible image. The factor estimating support device 10 displays the visible image added with the information.

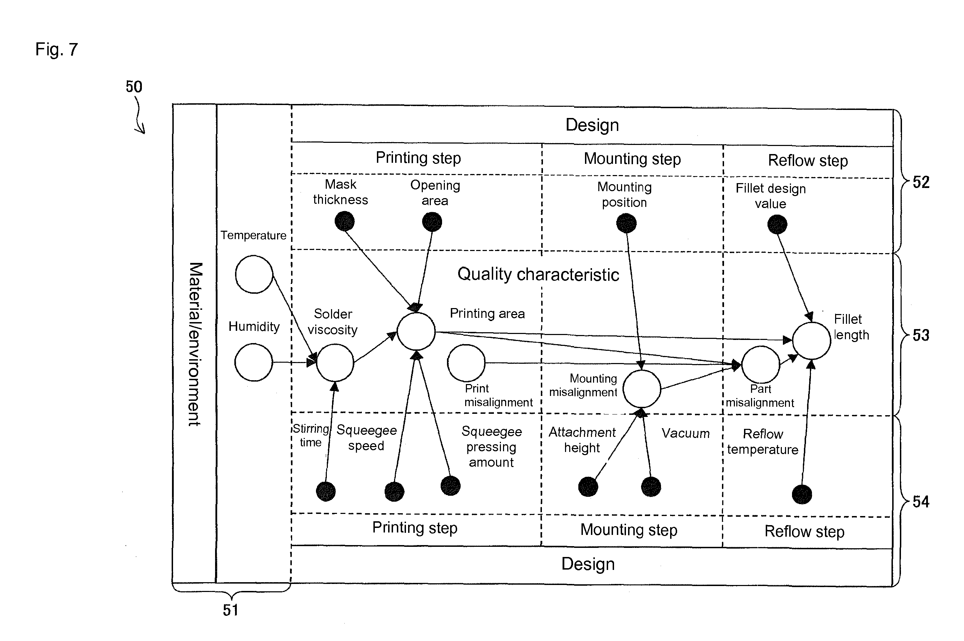

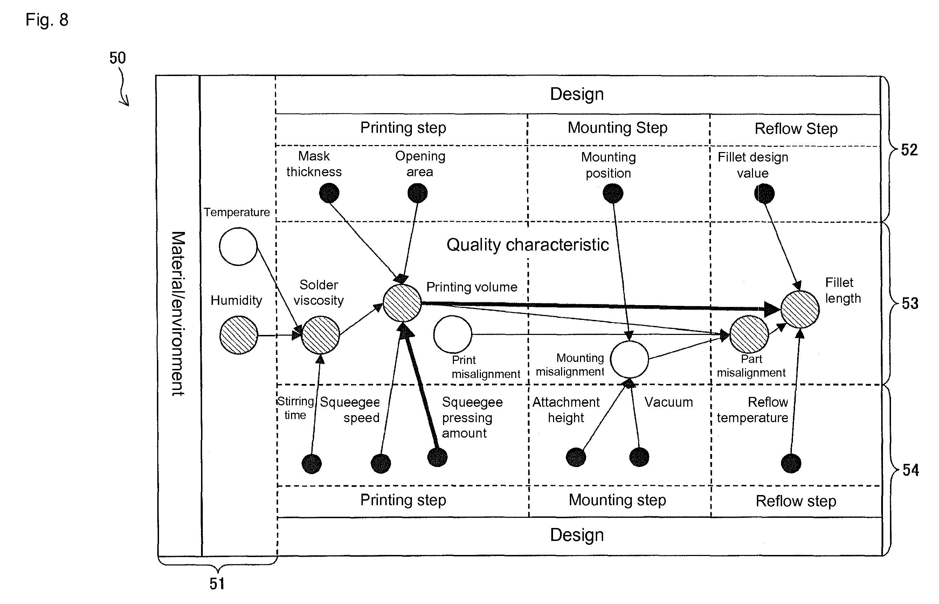

FIGS. 7 and 8 show the process of creating the visible image. FIG. 7 shows one example of the visible image of the causality created based on the causality information. As shown in the figure, the visible image 50 is divided into a left portion 51 and another portion, which another portion is divided into an upper portion 52, a middle portion 53, and a lower portion 54.

The upper portion 52, the middle portion 53, and the lower portion 54 are each divided into regions for a plurality of steps in the substrate mounting system 1, where each region has the left most side as the region of the most upstream step and the region of the downstream step is obtained towards the right side. That is, each of the upper portion 52, the middle portion 53, and the lower portion 54 is divided into the printing step, the mounting step, and the reflow step in order from the left.

The vertex of the variable that is fixed at the time of operation of the substrate mounting system 1 is drawn as a black circle in the upper portion 52 and the lower portion 54, and the vertex of the variable that changes at the time of operation of the substrate mounting system 1 is drawn as a white circle in the left portion 51 and the middle portion 53. The name of the variable corresponding to the relevant vertex is written near each vertex. The variable that is fixed has lower possibility of becoming the cause of abnormality compared to the variable that changes, and thus the black circle is drawn with a size smaller than the white circle.

The variable that is fixed at the time of operation of the substrate mounting system 1 includes a variable determined at the designing stage of the substrate mounting system 1 (hereinafter referred to as "variable of design"), and a variable set in the processing device 11 in the substrate mounting system 1 (hereinafter referred to as "variable of setting"). In the visible image 50 shown in FIG. 7, the vertex of the variable of design is drawn in the upper portion 52, and the vertex of the variable of setting is drawn in the lower portion 54. Examples of the variable of design include mask thickness, mounting position, and fillet design value; and examples of the variable of setting include stirring time, attachment height, and reflow temperature.

The variable that changes at the time of operation of the substrate mounting system 1 includes a variable indicating the state of the material used in the processing device 11 and a variable indicating the state of the environment in the processing device 11 (hereinafter referred to as "variable of material and environment"), and a variable indicating the quality characteristic tested in the test device 14 (hereinafter referred to as "variable of quality characteristic"). In the visible image 50 shown in FIG. 7, the vertex of the variable of material and environment is drawn in the left portion 51, and the variable of quality characteristic is drawn in the middle portion 53. Examples of the variable of material and environment include solder storage temperature and temperature inside the printing device 11a; and examples of the variable of quality characteristic include printing area of the solder, mounting misalignment of the part with respect to the substrate, and fillet length.

In FIG. 8, the vertex of the variable from which abnormality is detected is changed in the visible image 50 shown in FIG. 7. In the illustrated example, the white circle of the relevant vertex is shaded. The visible image 50 shown in FIG. 8 is displayed and referenced by the user, so that the user can easily understand the cause of abnormality. Since the variable from which the abnormality is detected is displayed according to the causality, the user can easily understand how the abnormality is propagating, and as a result, the persuasiveness of the cause of abnormality rises. Actually, color, character, pattern, or the like that draws the attention of the user such as coloring the white circle in red is desirable.

In the visible image 50 shown in FIGS. 7 and 8, the variables are arranged by being organized into design, setting, material/environment, and quality characteristic. Thus the visible image 50 becomes easy to see to users who reference the visible image, thereby enabling the user to more easily estimate the cause of abnormality.

Furthermore, in the example of FIG. 8, the heaviness of the arrow is changed so that the arrow becomes heavier the stronger the causal intensity using the causal intensity between the vertices contained in the causal structure data 42. Thus, when the user referencing the visible image 50 can take the causal intensity into consideration when estimating the cause of abnormality, whereby the user can more accurately estimate the cause of abnormality.

The details of the factor estimating support device 10 will now be described. FIG. 1 shows a schematic configuration of the factor estimating support device 10. As shown in the figure, the factor estimating support device 10 includes a control unit 20, a storage unit (variable history storage unit, causality storage unit) 21, a reception unit 22, an input unit 23, and a display unit 24.

The control unit 20 comprehensively controls the operation of each unit in the factor estimating support device 10, and is configured by a PC base computer etc. The operation control of each unit is performed by causing the computer to execute the control program. The storage unit 21 stores various information, and is configured by a non-volatile recording medium such as a hard disc device. The details of the control unit 20 and the storage unit 21 will be hereinafter described.

The reception unit 22 receives measurement data measured in each step of the substrate mounting system 1. The reception unit 22 stores the received measurement data in the storage unit 21. The reception unit 22 may receive the measurement data in a wired form or in a wireless form.

Specifically, the reception unit 22 receives material/environment data indicating the state of the environment in the processing device 11 or the state of the material used in the processing device 11 from the processing device 11, and stores the material/environment data in the storage unit 21. A sensor for detecting the state of the environment of the material may be newly arranged, and the reception unit 22 may receive the material/environment data from the sensor. As shown in FIG. 1, a material/environment input unit 25 may be newly arranged, and the material/environment data input through the material/environment input unit 25 by the user may be stored in the storage unit 21.

The reception unit 22 also receives test data indicating the test result of the test performed by the test device 14 from the test device 14 and stores the test data in the storage unit 21. The material/environment data stored in the storage unit 21 is hereinafter referred to as "material/environment history data", and the test data stored in the storage unit 21 is hereinafter referred to as "test history data".

Examples of the material/environment data include storage time and storage temperature of the solder paste, temperature and humidity inside the printing device 11a, and the like. Examples of the test data include measurement data such as solder viscosity and printing volume tested in the printing test device 14a, mounting misalignment tested in the attachment test device 14b, and misalignment and fillet length of the part tested in the soldering test device 14c. The fillet length represents the quality characteristic regarding the contour shape of the solder after the reflow step.

The input unit 23 accepts instruction input, information input, and the like from the user, and is configured by a key input device such as keyboard and button, a pointing device such as mouse, or the like.

In the present embodiment, the input unit 23 accepts the input of the causality structure data and the fixed control criterion data, and stores the same in the storage unit 21. The causality structure data indicates the causality between the variables with respect to various variables such as the material/environment data and the test data that fluctuate in the substrate mounting system. The causality structure data is created based on information from documents and humans. A plurality of causality structure data may be created. The fixed control criterion data contains target value and fixed control criterion of the final quality characteristic of the product manufactured in the substrate mounting system 1.

In addition to the input unit 23 or in place of the input unit 23, external input of information may be accepted using a scanner device for reading the printed information, a reception device for receiving signals through wireless or wired transmission medium, a reproduction device for reproducing data recorded on an external recording medium or inside the device, and the like.

The display unit 24 displays information based on instruction from the control unit 20 and is configured by a display device such as LCD (Liquid Crystal Display), PDP (Plasma Display Panel), CRT (Cathode Ray Tube), or the like. In addition to the display unit 24 or in place of the display unit 24, information may be output to the outside using a printout device for printing information on a printing medium such as paper, a transmission device for transmitting signals through the transmission medium, a recording device for recording data on the recording medium, and the like.

The details of the control unit 20 and the storage unit 21 will now be described. As shown in FIG. 1, the control unit 20 has a configuration including a causal intensity calculating part (causal intensity calculating means) 30, a variable control criterion setting part (criterion setting means) 31, a final quality abnormality detecting part (result abnormality determining means) 32, a variable abnormality detecting part (variable abnormality determining means) 33, and a visible image creating part (visible image crating means) 34. The storage unit 21 stores material/environment history data (history information) 40, test history data (history information) 41, causality structure data (causality information) 42, fixed control criterion data 43, and variable control criterion data 44.

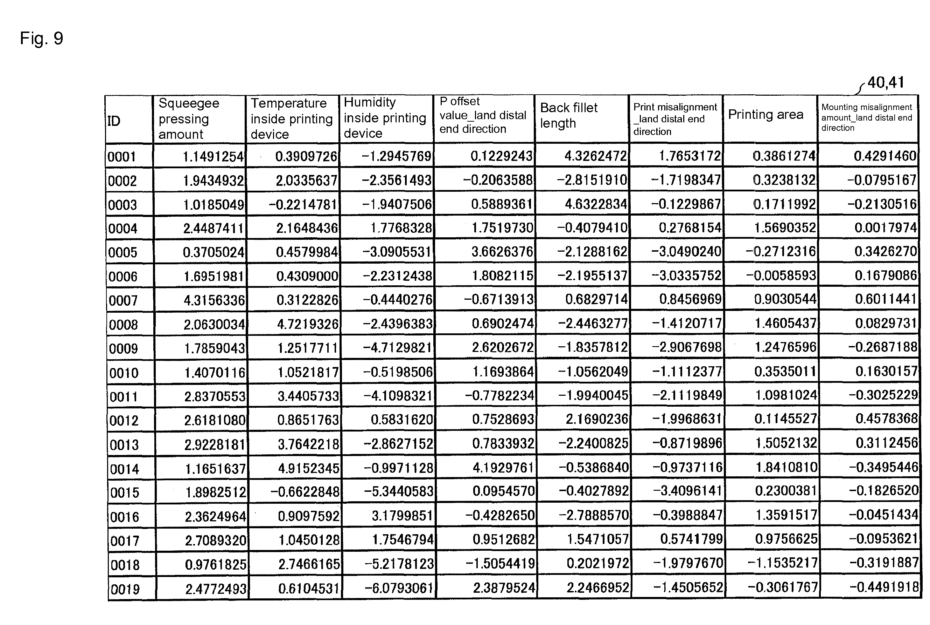

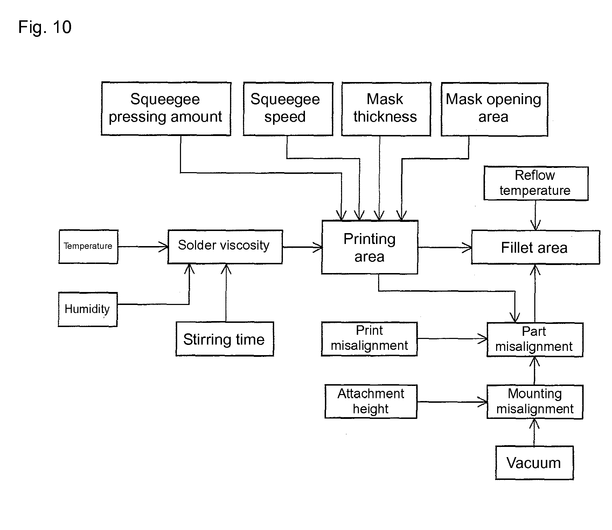

FIG. 9 collectively shows one example of the material/environment history data 40 and the test history data 41. As shown in the figure, the material/environment history data 40 and the test history data 41 contain an ID (identification number) for identifying the substrate, and various variables for every substrate manufactured. FIG. 10 shows one example of the causality structure data 42 in a form of a directed graph. The illustrated directed graph is a more detailed graph of the directed graph shown in FIG. 3, and the name of the variable is written on each vertex.

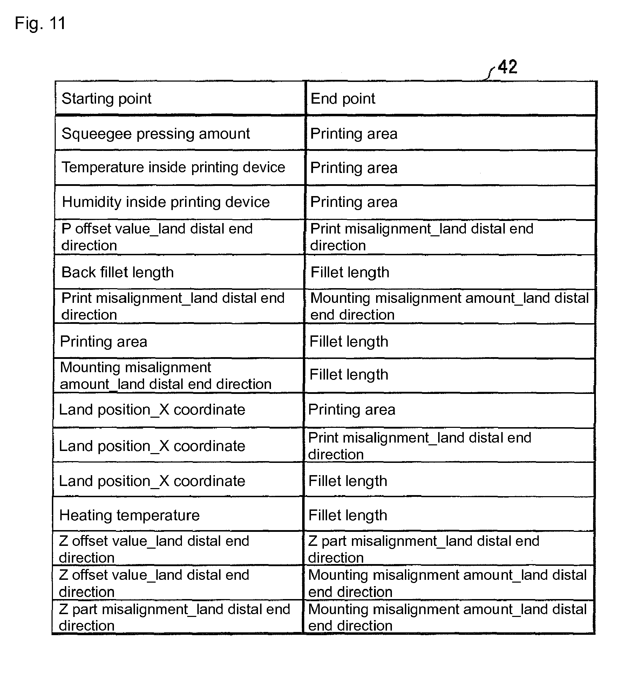

FIG. 11 shows one example of the causality structure data 42. The illustrated causality structure data 42 shows the directed graph shown in FIG. 10 in a table form. As shown in the figure, the causality structure data 42 contains the name of the variable corresponding to the parent vertex, which acts as a starting point of the arrow, and the name of the variable corresponding to the child vertex, which acts as an end point of the arrow, for each arrow. Although not shown, the causal intensity calculated in the causal intensity calculating part 30 is also included for every arrow.

Furthermore, although not shown, the causality structure data 42 contains category information indicating which category of design, setting, material/environment, and quality characteristic each variable belongs, and step information indicating which step of printing step, mounting step, and reflow step each variable belongs. The category information and the step information are used when the visible image creating part 34 creates the visible image, as hereinafter described.

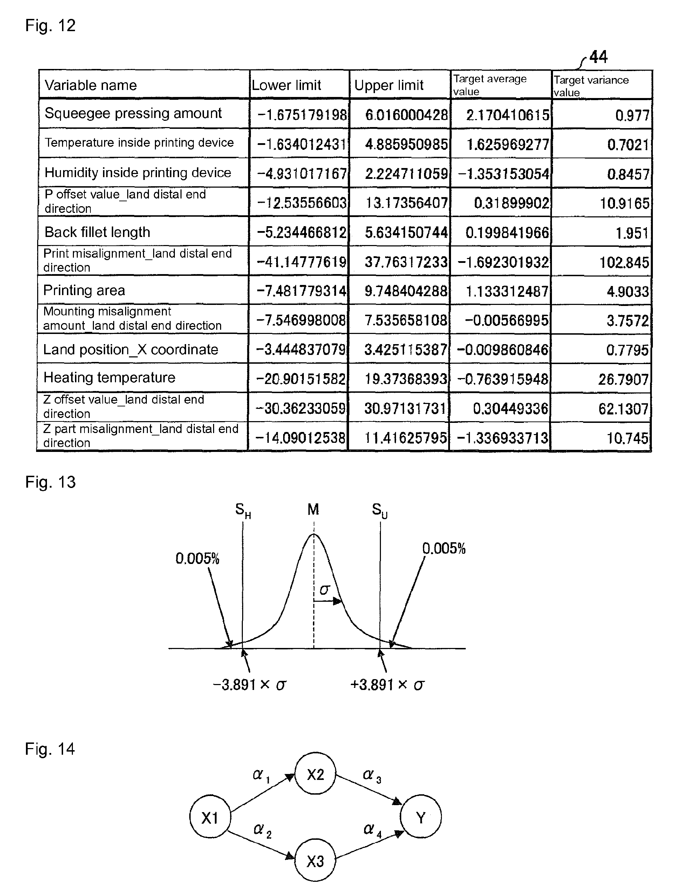

FIG. 12 shows one example of the variable control criterion data 44. As shown in the figure, the variable control criterion data 44 contains, for every variable, the name of the variable, the lower limit value $S_L$ and the upper limit value $S_U$ of the variable control criterion, the target average value, and the target variance value. The fixed control criterion data 43 contain similar information for every final characteristic.

The causal intensity calculating part 30 calculates the causal intensity between the variables in the causal structure data 42 using the material/environment history data 40 and the test history data 41. The method of calculating the causal intensity is the same as the above. The causal intensity calculating part 30 sends the calculated causal intensity to the variable control criterion setting part 31, and adds the same to the causal structure data 42 of the storage unit 21.

The variable control criterion setting part 31 sets the variable control criterion and the target variance value in each variable based on the causal intensity between the variables from the causal intensity calculating part 30 and the fixed control criterion data 43 stored in the storage unit 21. The variable control criterion setting part 31 stores the variable control criterion data 44 containing the variable control criterion set for every variable in the storage unit 21.

The setting of the variable control criterion and the target variance value will be specifically described. The target value M, the upper limit and lower limit fixed control criterion $S_U$, $S_L$, and the target fault rate are set to each final quality characteristic of the product, and stored in the storage unit 21 as fixed control criterion data 43. The target value M, and the upper limit and lower limit fixed control criterion $S_U$, $S_L$ are predefined from the design specification of the product, but the target fault rate can be changed according to the actual situation, the manufacturing cost, and the like of the substrate mounting system 1.

FIG. 13 shows the control criterion $S_L$, $S_U$ when the target fault rate of a certain variable is 1 00ppm=0.01 %.

If the probability distribution of the variable is a normal distribution, the event of occurring at a probability of 100% - 0.01 % = 99.99% is an event that the variable is within the range $M \pm 3.891 \times \sigma$. In this case, $\sigma$ is standard deviation.

Therefore, the target variance value $\sigma_Y^2$ for achieving the target fault rate of 0.01 % with respect to the target value M and the fixed control criterion $S_L$, $S_U$ is calculated by the following equation.

## Equation 2

$$\sigma_Y^2 = \left( \frac{M - S_L}{-3.891} \right)^2 = \left( \frac{S_U - M}{3.891} \right)^2 \qquad \cdot \cdot \cdot \ (3)$$

The variable control criterion setting part 31 then calculates the variance target value of the variable other than the final quality characteristic using the target variance value $\sigma_Y^2$ of the final quality characteristic and the causal intensity $\alpha$ calculated by the causal intensity calculating part 30. This calculation method will be described with reference to FIG. 14. FIG. 14 shows another example related to the causality information between the variables in a directed graph. Y in the figure indicates the variable of the final quality characteristic, and X1 to X3 indicate other variables. $\alpha_1$ to $\alpha_4$ respectively indicate the causal intensity between the variables. From the illustrated causal structure, the target variance value $\sigma_Y^2$ of the final quality characteristic Y is expressed with the following equation using the target variance value $\sigma_{X2}^2$ of the variable x2 and the target variance value $\sigma_{X3}^2$ of the variable X3.

## Equation 3

$$\sigma_Y^2 = \begin{bmatrix} \alpha_4 & \alpha_3 \end{bmatrix} \begin{bmatrix} \sigma_{X2}^2 & \sigma_{X2X3} \\ \sigma_{X2X3} & \sigma_{X3}^2 \end{bmatrix} \begin{bmatrix} \alpha_4 & \alpha_3 \end{bmatrix}^T \qquad \cdot \cdot \cdot \ (4)$$

In equation (4), $\sigma_{X2X3}$ is a covariance of variable X2 and variable X3. From equation (4), the target variance value $\sigma_Y^2$ of the final quality characteristic Y is found to be determined by the target variance value $\sigma_{X2}^2$ of the variable X2, the target variance value $\sigma_{X3}^2$ of the variable X3, the causal intensity $\alpha_3$ between the variable X2 and the final quality characteristic Y, and the causal intensity $\alpha_4$ between the variable X3 and the final quality characteristic Y.

In the causal structure shown in FIG. 14, variable X2 and variable X3 are in conditional independence relationship, and thus the covariance $\sigma_{X2X3}$ of variable X2 and variable X3 is zero. The equation (4) then becomes the following equation.

$$\sigma_Y^2 = \alpha_4^2 \times \sigma_{X2}^2 + \alpha_3^2 \times \sigma_{X3}^2 \quad \cdots \ (5)$$

Therefore, the target variance value $\sigma_{X2}^2$ of the variable X2 and the target variance value $\sigma_{X3}^2$ of the variable X3 are set as in the following equation using the target variance value $\sigma_y^2$ of the final quality characteristic Y, the causal intensity $\alpha_3$ between the variable X2 and the final quality characteristic Y, and the causal intensity $\alpha_4$ between the variable X3 and the final quality characteristic Y.

$$\sigma_{X2}^2 = (\alpha_3^2 + \alpha_4^2)/\alpha_4^2 \times \sigma_Y^2, \ \sigma_{X3}^2 = (\alpha_3^2 + \alpha_4^2)/\alpha_3^2 \times \sigma_Y^2 \quad \cdots \ (6)$$

The target variance value of each set variable and the target average value M of each variable are then used to calculate $M \pm 3.891 \times \sigma$, so that the variable control criterion $S_L$, $S_U$ of each variable are set.

The final quality abnormality detecting part 32 uses the test history data 41 and the fixed control criterion data 43 of the storage unit 21 to detect whether or not the final quality characteristic of the product is abnormal. The final quality abnormality detecting part 32 calculates the degree of abnormality regarding the final quality characteristic the abnormality is detected. The final quality abnormality detecting part 32 sends the information of the final quality characteristic the abnormality is detected and the degree of abnormality of the final quality characteristic to the variable abnormality detecting part 33 and the visible image creating part 34.

When receiving the information of the final quality characteristic in which the abnormality is detected from the final quality abnormality detecting part 32, the variable abnormality detecting part 33 uses the test history data 41 and the variable control criterion data 44 of the storage unit 21 to detect whether or not variables other than the final quality characteristic are abnormal. The variable abnormality detecting part 33 calculates the degree of abnormality regarding the variable in which the abnormality is detected. The variable abnormality detecting part 33 sends the information of the variable the abnormality is detected and the degree of abnormality of the variable to the visible image creating part 34.

The detection of abnormality in the final quality abnormality detecting part 32 and the variable abnormality detecting part 33 may use the process capability index $C_p$, as described above, may use a t-test and $X^2$ test, or may use a process capability index $C_{pk}$ taking into consideration the deviation in average value. The variable abnormality detecting part 33 reads out the causal structure containing the final quality characteristic detected as abnormal in the final quality abnormality detecting part 32 from the causal structure data 42 of the storage unit 21, and detect whether or not the variable contained in the read causal structure is abnormal.

The visible image creating part 34 reads out the causal structure data 42 from the storage unit 21 and creates the visible image of the causal structure. The visible image creating part 34 receives the information of the variable abnormality is detected from the final quality abnormality detecting part 32 and the variable abnormality detecting part 33, and adds information such as color, character, and pattern indicating abnormality to the variable in which abnormality is detected of the variables contained in the created visible image. The visible image creating part 34 transmits the visible image added with information with respect to the variable abnormality is detected to the display unit 24. The visible image is thereby displayed on the display unit 24.

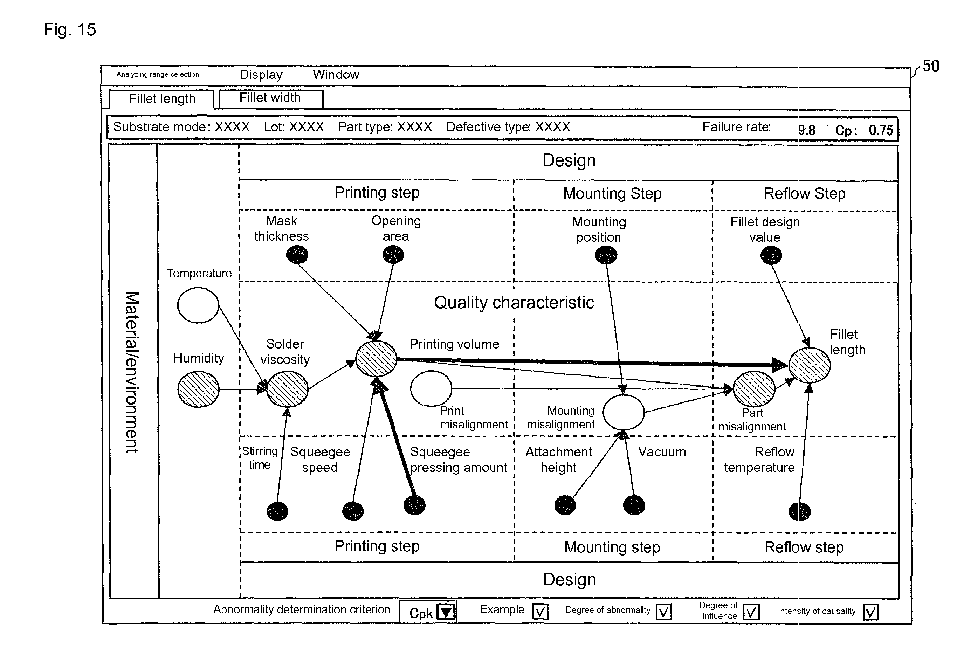

FIG. 15 shows one example of a visible image created by the visible image creating part 34. The visible image 50 shown has various information added to the visible image 50 shown in FIG. 8. Specifically, a menu bar, a tab for displaying the visible image for every final quality characteristic (in the illustrated example, fillet length and fillet width), various information related to the product such as model and lot of the substrate, various numerical values related to abnormality such as fault rate and process capability index Cp, type of abnormality criterion, and selection items of display option such as example are added.

The visible image 50 shown in FIG. 15 may have the dimension of each vertex become larger the larger the degree of abnormality. Thus, the degree of abnormality can be taken into consideration when the user referencing the visible image 50 estimates the cause of abnormality, and the user can more accurately estimate the cause of abnormality.

In the visible image 50 shown in FIG. 15, the vertex of a normal variable and the vertex of an abnormal variable are distinguishable, but the variable that cannot be determined whether abnormal or normal may be set as a cautious risky variable, and the vertex of such risky variable and the other vertices may be made distinguishable. For instance, the variable having the process capability index $C_p$ of less than 1.0 is set as an abnormal variable, the variable having the process capability index $C_p$ of greater than or equal to 1.0 and less than 1.33 as a risky variable, and the variable having the process capability index $C_p$ of greater than or equal to 1.33 as normal variable. The vertex of a blue variable is indicated in blue, the risky variable is indicated in yellow, and the abnormal variable is indicated in red.

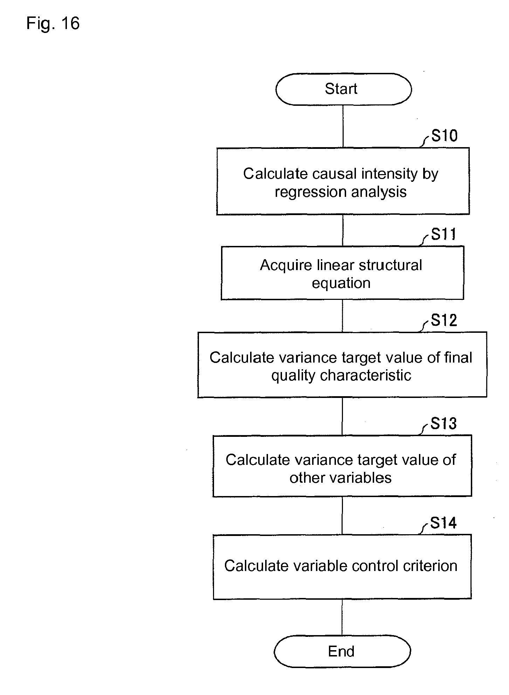

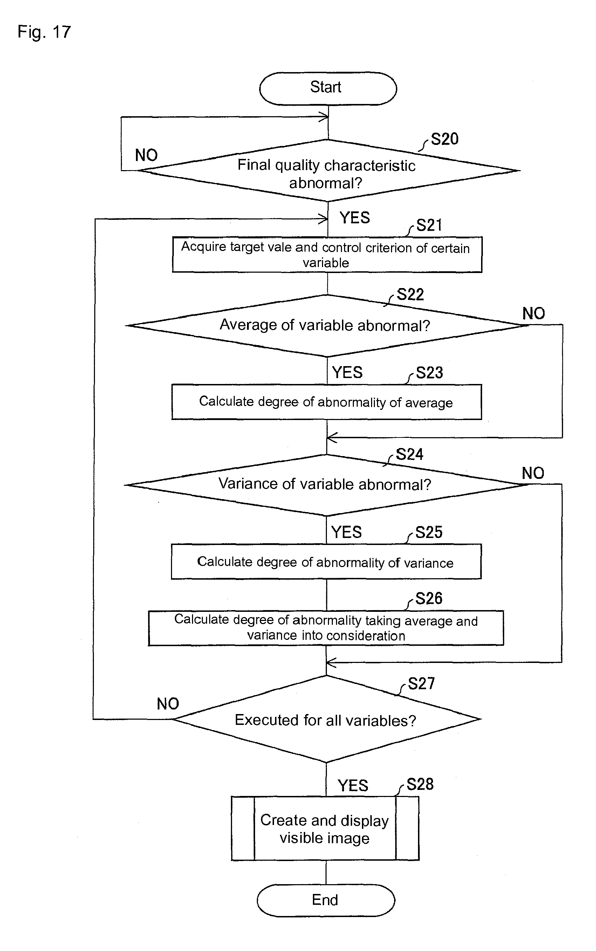

The processing operation in the control unit 20 of the factor estimating support device 10 having the above configuration will now be described with reference to FIGS. 16 and 17. FIG. 16 shows an outline of the processing operation of the causal intensity calculating part 30 and the variable control criterion setting part 31 in the control unit 20. The processing operation may be performed only once immediately after the operation of the substrate mounting system 1 or immediately after the change in setting of the device, performed on a constant basis, or performed constantly.

As shown in FIG. 16, the causal intensity calculating part 30 first calculates the causal intensity $\alpha$ between the variables in the causal structure data 42 using the material/environment history data 40 and the test history data 41 (step S10. Hereinafter simply referred to also as "S10". This is the same for other steps). The linear structural equation of equation (1) is acquired (S11).

The variable control criterion setting part 31 then calculates the target variance value of the final quality characteristics based on the target value M, the fixed control criterion $S_L$, $S_U$, and the target fault rate contained in the fixed control criterion data 43 of the storage unit 21 (S12). The target variance value of the final quality characteristic can be contained in the fixed control criterion data 43 in place of the target fault rate. In this case, the variable control criterion setting part 31 acquires the target variance value of the final quality characteristic contained in the fixed control criterion data 43 from the storage unit 21 in place of step S12.

The variable control criterion setting part 31 then calculates the variance target value of the variable other than the final quality characteristic using the target variance value $\sigma_Y^2$ of the final quality characteristic calculated in S12 and the causal intensity $\alpha$ calculated by the causal intensity calculating part 30 (S13).

The variable control criterion setting part 31 then calculates, for every variable other than the final quality characteristic, the value of the variable control criterion $S_L$, $S_U$ by equation (3) using the target variance value $\sigma_X^2$ calculated in step S13 and the predetermined target value M (S14). Subsequently, the processing operation is terminated in the causal intensity calculating part 30 and the variable control criterion setting part 31.

FIG. 17 shows an outline of the processing operation of the final quality abnormality detecting part 32, the variable abnormality detecting part 33, and the visible image creating part 34 in the control unit 20. As shown in the figure, the process waits until the final quality abnormality detecting part 32 detects the abnormality of the final quality characteristic (S20). The determination of abnormality of the final quality characteristic may be performed by the process similar to step S22 and step S24.

When the abnormality is detected, the variable abnormality detecting part 33 acquires the target variance value, the target value, and the variable control criterion contained in the variable control criterion data 44 of the storage unit 21 regarding a certain variable other than the final quality characteristic (S21). The variable abnormality detecting part 33 acquires the history data of the material/environment history data 40 or the test history data 41 of the storage unit 21, and calculates the average value of the variable.

The variable abnormality detecting part 33 then determines whether or not the calculated average value is abnormal (S22). One example of the determination method includes a determination method by t-test below. That is, the significant level a (normally 0.05) for the test stored in advance in the storage unit 21 is acquired. The test statistic T is calculated with the following equation using the history data of the variable.

## Equation 4

$$T = \frac{\overline{x} - \mu_0}{\sqrt{V_x^2 / n}} \qquad \cdots \quad (7)$$

(X: data series, $\overline{x}$: average value of x, $\mu_0$: target value, $V_x^2$: unbiased variance value, n: the number of data)

The t value $t_a$ of the t distribution having a degree of freedom (n-1) with respect to the significant level a is acquired from the t distribution table. The t value $t_a$ may be stored in the storage unit 21 in place of the significant level a. The acquired t value $t_a$ and the test statistic T calculated by equation (7) are then compared, where the average value of the variable is determined as abnormal if $T > t_a$. A known determination method other than the t-test may be used.

If the average value of the variable is determined as abnormal in step S22, the variable abnormality detecting part 33 calculates the degree of abnormality of the average value (S23). The degree of abnormality of the average value is obtained by (deviation from variable control criterion of average value)/(width of variable control criterion).

The variable abnormality detecting part 33 calculates the variance value of the variable using the history data of the variable, and determines whether or not the calculated variance value is abnormal (S24). One example of the determination method includes determination method by $X^2$-test below. That is, the significant level a is first acquired. The test statistic $X_0^2$ is calculated with the following equation using the history data of the variable.

## Equation 5

$$\chi_0^2 = \frac{\sum_{i=1}^{n} (x_i - \mu)^2}{\sigma_0^2} \qquad \cdots \quad (8)$$

(X$_i$: data series, $\mu$: average target value, $\sigma_0^2$: variance target value, n: the number of data)

The $X^2$ value $X_a^2$ of the $X^2$ distribution having a degree of freedom (n - 1) with respect to the significant level a is acquired from the $X^2$ distribution table. The $X^2$ value $X_a^2$ may be stored in the storage unit 21 in place of the significant level a. The acquired $X^2$ value $X_a^2$ and the test statistic $X_0^2$ calculated by equation (8) are then compared, where the variance value of the variable is determined as abnormal if $X_0^2 > X_a^2$. A known determination method other than the $X^2$ test may be used.

In step S24, if the variance value of the variable is abnormal, the variable abnormality detecting part 33 calculates the degree of abnormality of the variance value (S25), and calculates the degree of abnormality taking into consideration the average value and the variance value of the variable (S26). The degree of abnormality of the variance value is the process capability index $C_p$, and is obtained by equation (2). The degree of combined abnormality is obtained by multiplying the degree of abnormality of the average value and the degree of abnormality of the variance value.

Specifically, the degree $C_{pk}$ of abnormality taking into consideration the average value and the variance value is calculated with the following equation. Here, X⁻ (for the sake of convenience, X with bar is described in such manner) is the average value of the variable.

## Equation 6

$$C_{PK} = (1-K)C_P \quad (0 < K < 1) \left.\right\} \quad \cdots \quad (9)$$
$$C_{PK} = 0 \qquad (K \geq 1)$$

$$\left( \quad K = \frac{|M - \overline{X}|}{\dfrac{S_U - S_L}{2}} \quad \right)$$

The variable abnormality detecting part 33 repeats steps S21 to S26 for all the variables other than the final quality characteristic (S27). The visible image creating part 34 performs a creating and displaying process of the visible image creating the visible image 50 and displaying the same on the display unit 24 using the information of the variable determined as abnormal by the variable abnormality detecting part 33 and the causal structure data 42 of the storage unit 21 (S28). Subsequently, the processing operations in the final quality abnormality detecting part 32, the variable abnormality detecting part 33, and the visible image creating part 34 are terminated.

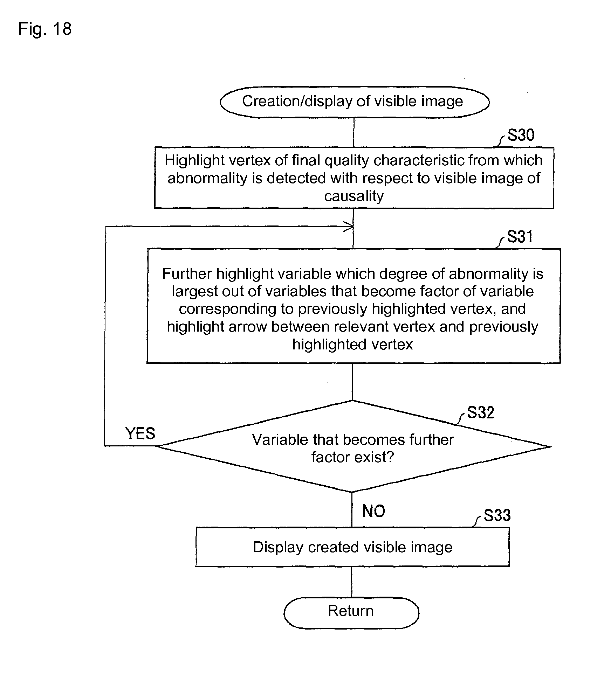

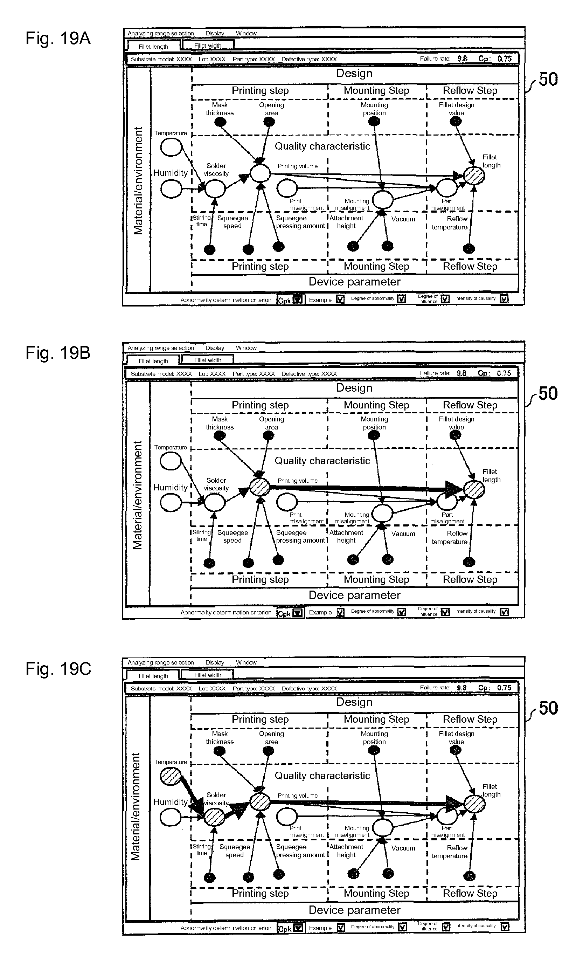

Specific examples of the creating/displaying process (S28) of the visible image will now be described with reference to FIGS. 18 and 19. FIG. 18 shows a flow of process when the visible image creating part 34 automatically performs the visible image creating/displaying process (S28). FIGS. 19A to 19C show change in the visible image 50 as a result of performing the process shown in FIG. 18.

As shown in FIG. 18, change is made to a visible image in which the vertex of the final quality characteristic, from which the final quality abnormality detecting part 32 has detected abnormality, with respect to the visible image 50 shown in FIG. 7, that is, the visible image of the causality is highlighted (S30). FIG. 19A shows the visible image 50 changed by step S30. In the illustrated example, the vertex of the fillet length is highlighted.

The variable which degree of abnormality calculated by the variable abnormality detecting part 33 is the largest out of the variables that become the factor of variable corresponding to the previously highlighted vertex is specified. Change is then made to a visible image in which the vertex of the specified variable is further highlighted, and change is again made to a visible image in which the arrow between the relevant vertex and the previously highlighted vertex is further highlighted (S31).

FIG. 19B shows a visible image 50 changed by step S31 with respect to the visible image 50 shown in FIG. 19A. In the example of FIG. 19B, the vertex of printing volume is further highlighted, and the arrow between the vertex of the printing volume and the vertex of the fillet length is further highlighted, compared to the example of FIG. 19A.

Determination is made on whether or not a variable, that becomes a further factor, exists, that is, whether or not a variable that becomes the factor of the variable corresponding to the vertex highlighted in the previous step (S31) exists (S32). If such variable exists, the process returns to the previous step (S31), and the operation is repeated. If the variable does not exist, the created visible image 50 is displayed on the display unit 24 (S33). Subsequently, the visible image creating/displaying process is terminated, and the process returns to the original routine.

FIG. 19C shows the visible image 50 created as a result of the process shown in FIG. 18. In the example of FIG. 19C, the vertex of solder viscosity and the vertex of temperature are further highlighted, and the arrow between the vertex of solder viscosity and the vertex of printing volume, as well as the arrow between the vertex of temperature and the vertex of solder viscosity are highlighted, compared to the example of FIG. 19B.

Therefore, the trouble of the user can be omitted by automatically displaying the visible image 50 shown in FIG. 19C on the display unit 24. Since the causality of the variable having the largest degree of abnormality is visualized, the user can easily estimate the main cause of abnormality.

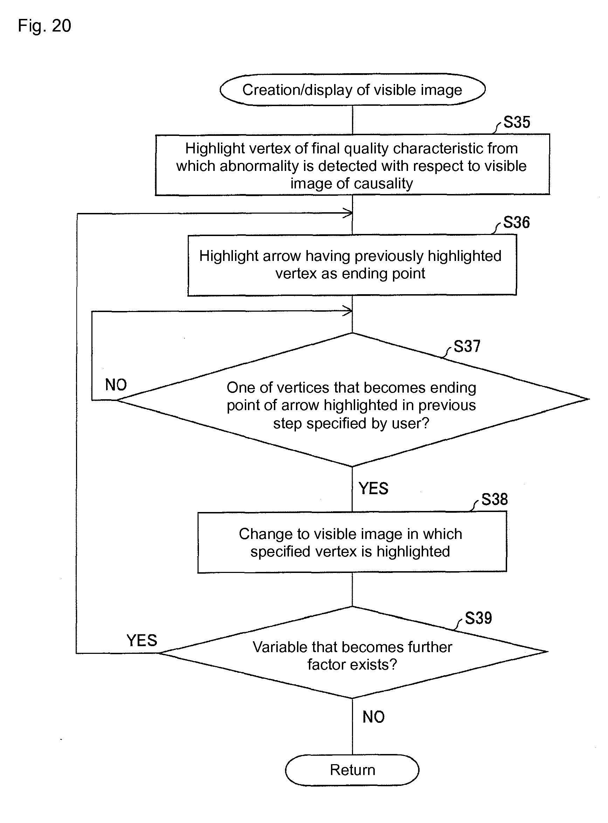

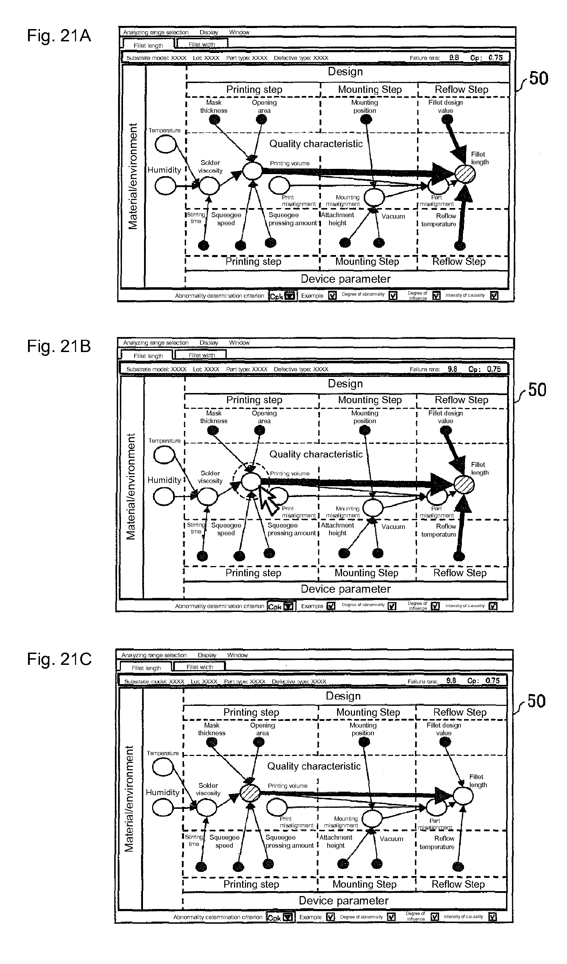

Another example of the visible image creating/displaying process (S28) will be described with reference to FIGS. 20 and 21. FIG. 20 shows a flow of process of when the visible image creating part 34 performs the visible image creating/displaying process (S28) based on the instruction of the user. FIGS. 21A to 21C show change in the visible image 50 as a result of performing the process shown in FIG. 20.

As shown in FIG. 20, change is made to a visible image in which the vertex of the final quality characteristic, from which the final quality abnormality detecting part 32 has detected abnormality, with respect to the visible image of causality shown in FIG. 7 is highlighted (S35). The changed visible image 50 is the same as the visible image 50 shown in FIG. 19A.

An arrow where the previously highlighted vertex is the end point is highlighted (S36). Thus, the causality resulting in the variable corresponding to the previously highlighted vertex is highlighted. Furthermore, the heaviness of the arrow is changed based on the causal intensity contained in the causal structure data 42 of the storage unit 21. That is, the arrow is heavier the stronger the causal intensity.

FIG. 21A shows the visible image 50 changed by step S36 with respect to the visible image 50 shown in FIG. 19A. In the example of FIG. 21A, the arrows between each vertex of fillet design value, printing volume, part misalignment, and reflow temperature and the vertex of the fillet length are further highlighted, compared to the example of FIG. 19A. Of the highlighted arrows, the arrow between the vertex of the printing volume and the vertex of the fillet length is heavily displayed.

The process waits until the user specifies one of the vertices that becomes the ending point of the arrow highlighted in the previous step (S36) through an input means such as the input unit 23 (S37). FIG. 21B shows a state in which the user moves the pointer to the vertex of the printing volume with respect to the visible image 50 shown in FIG. 21A. Furthermore, in the illustrated example, when the position pointed by the pointer is contained in the region of a certain vertex, the broken line surrounding the relevant vertex is displayed. The user can then easily understand which vertex the pointer is pointing even if the vertices are close.

When the user specifies one of the vertices, change is made to a visible image 50 in which the specified vertex is highlighted (S38). FIG. 21C shows a state in which the vertex of the printing volume specified by the user is highlighted with respect to the visible image 50 shown in FIG. 21B. In the illustrated example, the arrow having the specified vertex as the starting point of the arrows highlighted in step S36 is changed to an arrow highlighted with a predetermined heaviness, and the arrows having the vertices other than such vertex as the starting point are returned to the normal arrow. The visible image 50 that is easy to see for the user is thereby obtained.

Determination is made on whether or not a variable, that becomes a further factor, exists, that is, whether or not a variable that becomes the factor of the variable corresponding to the vertex highlighted in the previous step (S38) exists (S39). If such variable exists, the process returns to step S36, and the operation is repeated. If the variable does not exist, the visible image creating/displaying process is terminated, and the process returns to the original routine.

When the visible image 50 is created by the process shown in FIG. 20, the user can understand how the abnormality propagates along the causality using his/her knowledge of the causality and the knowledge of the causality provided by the device.

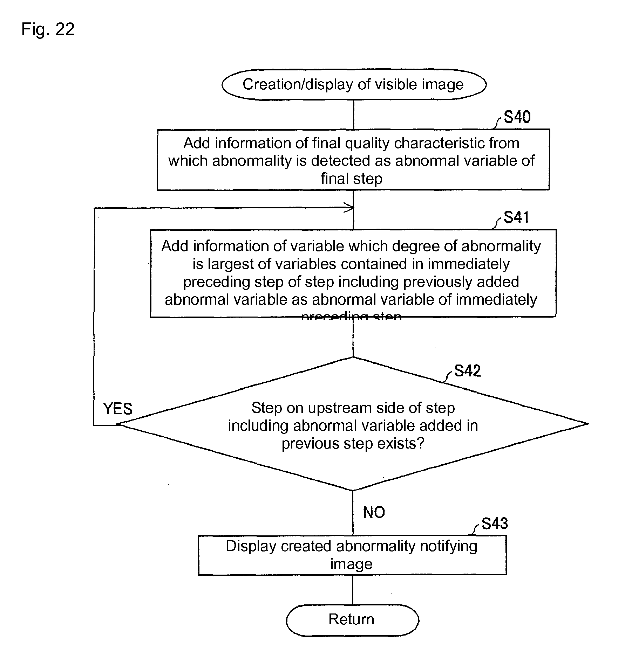

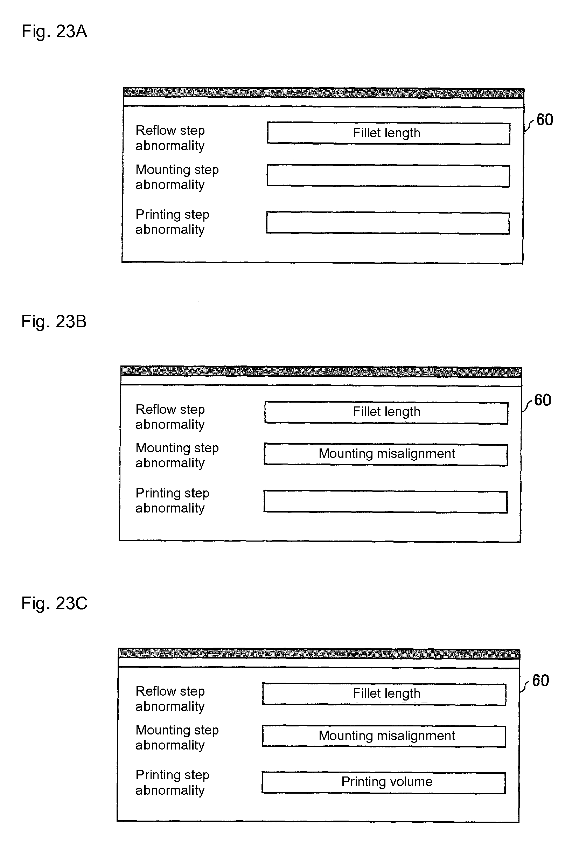

The visible image creating part 34 may display the information of the variable having abnormality by steps instead of creating and displaying the visible image 50. FIG. 22 shows a flow of process when the visible image creating part 34 displays the main variable having abnormality by steps on the display unit 24. FIGS. 23A to 23C show change in an abnormality notifying image 60 for notifying abnormality, which is the image created by performing the process shown in FIG. 22.

As shown in FIG. 22, first, the information of the final quality characteristic from which the final quality abnormality detecting part 32 has detected abnormality is added to the abnormality notifying image 60 as abnormal variable of the final step (S40). FIG. 23A shows the abnormality notifying image 60 added with information in step S40. In the illustrated example, "fillet length" is added to the field showing the abnormality of the reflow step or the final step.

The variable which degree of abnormality calculated by the variable abnormality detecting part 33 is the largest of the variables contained in the immediately preceding step of the step including the previously added abnormal variable is specified. The information of the specified variable is added to the abnormality notifying image 60 as abnormal variable of the immediately preceding step (S41). FIG. 23B shows the abnormality notifying image 60 added with information in step S41. In the illustrated example, "mounting misalignment" is added to the field showing the abnormality of the mounting step or the immediately preceding step of the final step.

Determination is made on whether a step on the upstream side from the step including the abnormal variable added in the previous step (S41) exists (S42). If the step exists, the process returns to the previous step (S41) and the operation is repeated. If the step does not exist, the created abnormality notifying image 60 is displayed on the display unit 24 (S43). Subsequently, the process of the visible image creating part 34 is terminated, and the process returns to the original routine.

FIG. 23C shows the abnormality notifying image 60 created as a result of the process shown in FIG. 22. In the example of FIG. 22C, "printing volume" is added to the field indicating abnormality of the printing step or the remaining step, compared to the example of FIG. 22B. The user can then rapidly understand the main variable that becomes abnormal in each step.

In the above embodiment, the user inputs the operation at the input unit 23 of the factor estimating support device 10, and displays various screens on the display unit 24. Apart from the factor estimating support device 10, a terminal at where the user inputs the operation is separately arranged while being connected to a communication network, so that data input to the factor estimating support device 10 and display of various screens are performed by the terminal device.

[Second embodiment]

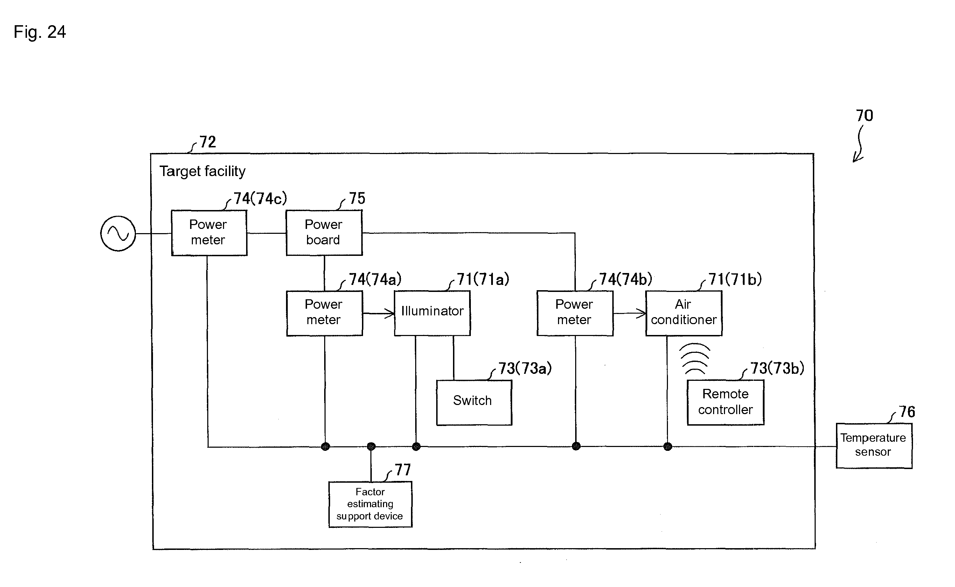

Another embodiment of the present invention will now be described with reference to FIGS. 24 to 33. In the present embodiment, the present invention is applied to a power supply system for supplying power to various electrical equipments in a facility that acts as a target (hereinafter referred to as "target facility") to estimate an electrical equipment that is consuming wasteful power.

Recently in the industrial world, reduction of power consumption amount of various electrical equipments used in time of production is desired to reduce the production cost. Furthermore, reduction in power consumption amount at a national level is desired for a global warming countermeasure.

However, a great number of electrical equipments are arranged in facilities such as factory and residential buildings, and it is not easy to specify to which electrical equipment and to what extent the operation should be performed to suppress the entire power consumption amount. This is because even if two electrical equipments are separately arranged and are separately operated, if one electrical equipment is used, the power consumption of the other electrical equipment changes.

For instance, an illuminator and an air conditioner are separately arranged and are separately operated, but if the illuminator is lighted, the temperature inside the facility rises. Thus, in the air conditioner, the power consumption increases during summer time since the cooling function needs to be raised and the power consumption lowers during the winter time since the heating function needs to be lowered in order to maintain the temperature inside the facility to a set temperature.

When the set temperature of the air conditioner is changed to a temperature comfortable for a human, the human hesitates to go out of the target facility. This is particularly significant when the outside temperature is a temperature undesirable for the human. Thus, in the case of the illuminator that is automatically lighted when detecting the presence of the human, the lighting time becomes long, and as a result, the power consumption amount of the illuminator increases. When the set temperature of the air conditioner is changed to a temperature undesirable for a human, the human immediately goes out of the target facility. This is particularly significant when the outside temperature is a temperature comfortable for the human. Thus, the lighting time of the illuminator becomes short, and as a result, the power consumption amount of the illuminator decreases.

Professionals skilled in saving energy know through experience the relationship of influence between the electrical equipments regarding the power consumption amount and the way of interpreting such influence, and know through experience various countermeasures for reducing the power consumption amount. Thus, conventionally, the professionals investigate the facility, specify the electrical equipment which power consumption amount should be suppressed, and give an advice for suppressing the power consumption amount based thereon to the supervisor of the facility.

However, since such professionals are limited in number, it takes a long period of time to complete giving the advice on all the facilities including residential buildings. When receiving advice from the professionals at each household, the proportionate amount of fee needs to be paid, and thus the burden of cost at each household increases.

In the power supply system of the present invention, how the power consumption amount influences between the electrical equipments is specified in the causal structure, and information indicating that there is waste with respect to the power consumption amount of the electrical equipment determined to have waste is added to the visible image in which the causality is visualized. The visible image is output to the outside through output means such as display means and printing means to be referenced by the user, so that the user can easily understand the electrical equipment having waste, and the user can also easily understand how the waste is propagating along the causality, whereby the user can easily estimate the electrical equipment that is the factor of power consumption amount.

Details of the power supply system of the present embodiment will now be described. FIG. 24 shows a schematic configuration of a power supply system 70 according to the present embodiment. The power supply system 70 includes various electrical equipments 71 arranged in a target facility 72. In the illustrated example, an illuminator 71 a for lighting the inside of the target facility 72, and an air conditioner 71 b for performing air adjustment of the inside of the target facility 72 are arranged as electrical equipments 71.

The power supply system 70 has an operation device 73 for the user to operate each electrical equipment 71 arranged in the target facility 72. In the illustrated example, a switch 73a for operating the illuminator 71 a and remote controller 73b for operating the air conditioner 71 b are arranged in the target facility 72 as the operation device 73.

The power is externally supplied to each electrical equipment 71 through a power board 75. The power supply system 70 includes a power meter 74 for measuring the power supplied to the electrical equipment 71 and the power board 75. An illustrated example, power meters 74a, 74b, and 74c for measuring the power supplied respectively to the illuminator 71 a, the air conditioner 71 b, and the power board 75. Here, the power meter 74c for measuring the power externally supplied to the power board 75 measures the total value of the power supplied to the target facility 72.

The power supply system 70 includes various sensors for measuring the physical quantity having the possibility of influencing the power consumption amount of the electrical equipment 71. In the illustrated example, the power supply system 70 includes a temperature sensor 76 for measuring the outside temperature, which is the temperature of the outside of the target facility 72.

In the present embodiment, the power supply system 70 includes a factor estimating support device 77 for supporting the user to estimate the electrical equipment, which is the factor of waste of the power consumption amount. The factor estimating support device 77, the illuminator 71 a, the air conditioner 71 b, and the power meters 74a to 74c form the communication network by being connected to each other with the communication line. The communication network may be any type as long as each device is communicable with each other such as a mode in which the LAN (Local Area Network) is formed.

In the present embodiment, a configuration in which the power meter 74 is arranged in correspondence to the electrical equipment 71 and the power board 75 is adopted, but some power meters 74 other than the power meter 74c for measuring the total value of the power supplied to the target facility 72 may be omitted.

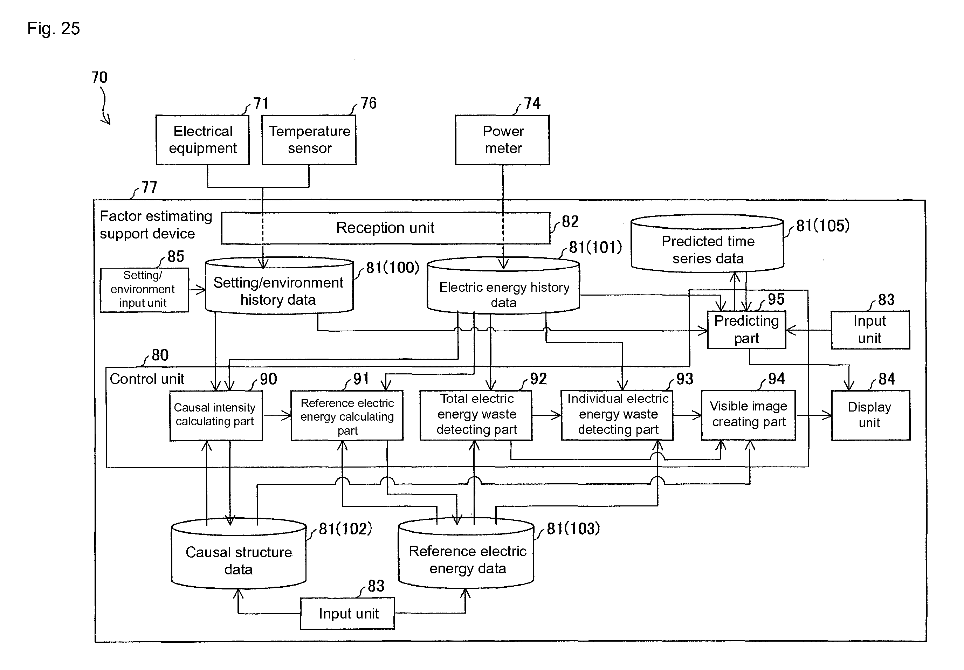

The details of the factor estimating support device 77 will be described with reference to FIGS. 25 to 33. Same reference numerals are denoted for the configuration having the function similar to the configuration described in the above embodiment, and the description thereof will be omitted.

FIG. 25 shows a schematic configuration of the factor estimating support device 77. As shown in the figure, the factor estimating support device 77 has a configuration including a control unit 80, a storage unit (variable history storage unit, causality storage unit) 81, a reception unit 82, an input unit 83, and a display unit 84. The outline of the control unit 80, the storage unit 81, the reception unit 82, the input unit 83, and the display unit 84 is similar to the outline of the control unit 20, the storage unit 21, the reception unit 22, the input unit 23, and the display unit 24 shown in FIG. 1, and thus the description thereof will be omitted.

The details of the reception unit 82 will be first described. In the present embodiment, the reception unit 82 receives the setting/environment data indicating the state of the environment inside and outside of the target facility 72 or the state set in the electrical equipment 71 from various equipments such as the electrical equipment 71, the sensor, the operation device 73, and the like, and stores the same in the storage unit 81. As shown in FIG. 25, a setting/ environment input unit 85 may be newly arranged, and the setting/environment data input by the user through the setting/ environment input unit 85 may be stored in the storage unit 81.

The reception unit 82 receives the electric energy data indicating the electric energy amount measured by the power meter 74 from the power meter 74 and stores the same in the storage unit 81. The setting/environment data stored in the storage unit 81 is referred to as "setting/environment history data", and the electric energy data stored in the storage unit 81 is referred to as "electric energy history data". The setting/environment history data and the electric energy history data are collectively referred to as "history data".

Specifically, the reception unit 82 receives data indicating ON/OFF of the illuminator 71a, set temperature of the air conditioner 71b, and the outside temperature measured by the temperature sensor 76 as the setting/environment data, but may receive other setting/environment data. Other examples of the setting/environment data include data such as luminance of the illuminator 71a, ON/OFF of the air conditioner 71b, temperature and heat capacity of the target facility, open/close of the door and the window connecting the outside and the inside of the target facility, and the like.

In the examples of FIGS. 24 and 25, the reception unit 82 of the factor estimating support device 77 receive the set temperature from the air conditioner 71b, but may acquire the same from the remote controller 73b. Similarly, the ON/OFF of the illuminator 71a is acquired from the illuminator 71a, but may be acquired from the switch 73a.

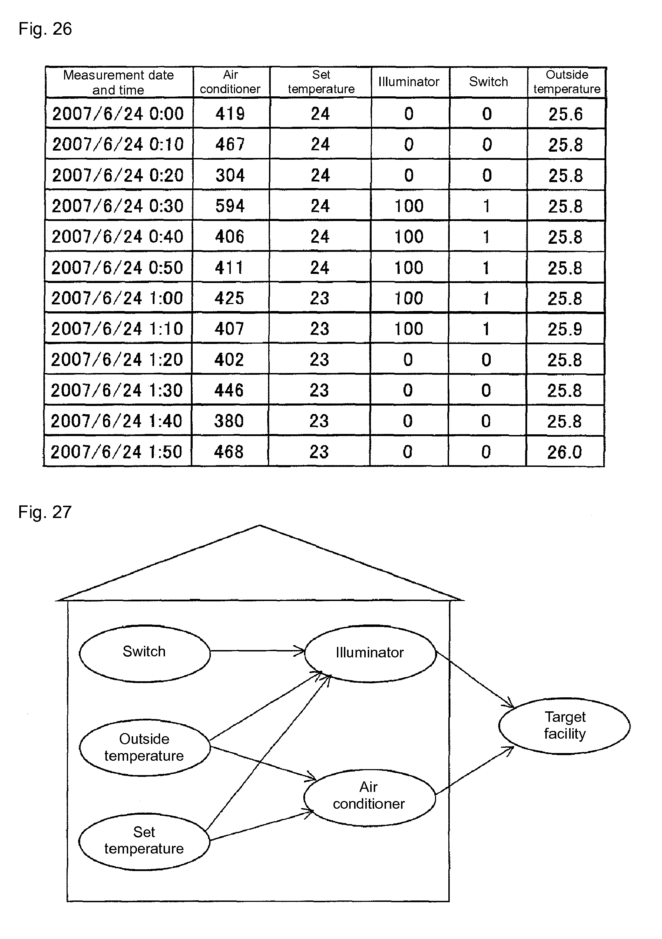

FIG. 26 shows one example of history data of each variable. As shown in the figure, the history data of each variable is associated with measurement date and time. The measurement date and time field is described with numerical values in "year/month/date hour : minute". The unit of the illuminator 71a and the air conditioner 71b field is W, and the unit of the field of set temperature of the remote controller 73b and the outside temperature of the temperature sensor 76 is °C. The numerical value of the switch field is 0 indicating OFF or 1 indicating ON.

The details of the input unit 83 will be described. In the present embodiment, the input unit 83 accepts input of causal structure data and the reference electric energy data, and stores the same in the storage unit 81. The causal structure data indicates the causality between the variables regarding various variables such as the setting/environment data and the electric energy data that vary in the substrate mounting system 1. The causal structure data is created based on the information from documents and humans. A plurality of causal structure data may be created.

FIG. 27 shows one example of the causality information in the present embodiment in a directed graph. Regarding the names of the variable in the figure, "switch" indicates ON/OFF of the switch 73a, "outside temperature" indicates outside temperature measured by the temperature sensor 76, and "set temperature" indicates the set temperature of the remote controller 73b. "Illuminator", "air conditioner", and "target facility" respectively indicate the power consumption amount of the illuminator 71a, the air conditioner 71b, and the target facility 72.

In the example of FIG. 27, ON/OFF of the switch 73a influences the power consumption amount of the illuminator 71a, and also influences the outside temperature measured by the temperature sensor 76, the set temperature of the remote controller 73b, and the power consumption amount of the air conditioner 71b. The power consumption amount of the illuminator 71a and the power consumption amount of the air conditioner 71b influence the total value (hereinafter referred to as "total power consumption amount") of the power consumption amount of the electrical equipment 71 in the target facility 72.

Furthermore, in the example of FIG. 27, ON/OFF of the switch 73a in the illuminator 71a influences the power consumption amount of the air conditioner 71b, and the set temperature of the remote controller 73b and the outside temperature measured by the temperature sensor 76 influence the power consumption amount of the illuminator 71a. The reasons therefor are as described above, and thus the description thereof will be omitted.

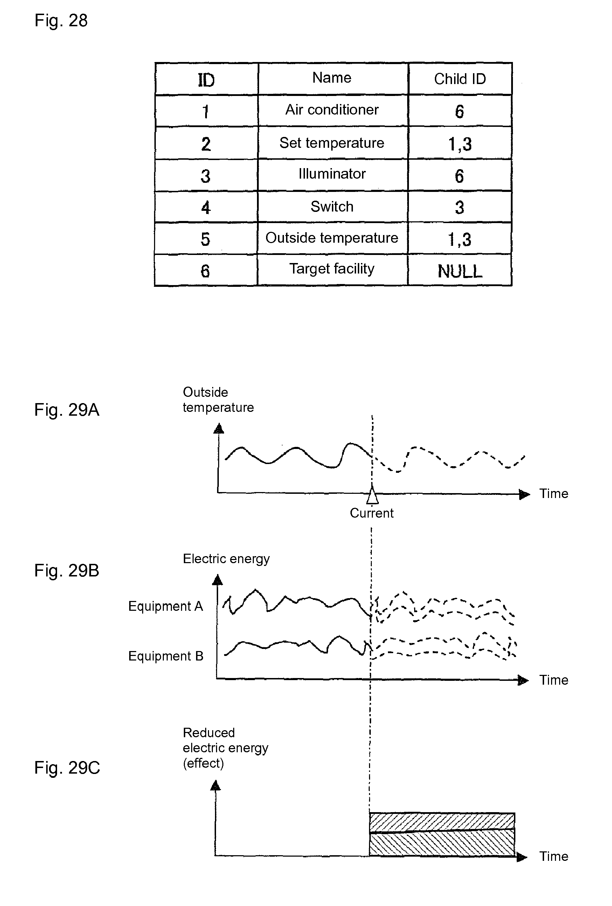

FIG. 28 shows one example of causal structure data, and shows the directed graph shown in FIG. 27 in a table form. As shown in the figure, the causal structure data contains, for every variable, an ID (identification number) for identifying the variable, the name of the variable, and an ID (child ID) of the variable corresponding to the vertex of the child that becomes the ending point of the arrow having the relevant variable as the starting point. Although not shown, the causal structure data contains causal intensity calculated in a causal intensity calculating part 90, to be hereinafter described, for every arrow.

The reference electric energy data contains data of the power consumption amount at the reference state of the plurality of electrical equipments 71 arranged in the target facility 72, and the total value thereof. Currently, most of the unnecessary power consumption amount is consumed because the electrical equipment 71 is in operation or in standby although the relevant electrical equipment 71 is not in use. Thus, in the present embodiment, "scheduled period in which the electrical equipment is scheduled to be used" × "rated output of the electrical equipment" is adopted for the reference electric energy of the electrical equipment 71 having a non-used period.

Some electrical equipments 71 such as a refrigerator exist that need to be constantly operated. The waste of such electrical equipment 71 is that the power consumption amount varies. If the variation is large, the rated value of the power to be supplied to the relevant electrical equipment 71 needs to be increased, whereby an extra power needs to be supplied compared to when the variation is small. Thus, in the present embodiment, the average value and the variance value of the power consumption amount are used for the reference electric energy of the electrical equipment 71 that is constantly operating. The average value and the variance value of the power consumption amount are calculated from the electric energy history data.

Assume a case where a great number of electrical equipments 71 exist in the target facility 72 such as a factory. In this case, the electrical equipment 71 is categorized based on its function and the location in the target facility 72, and the average value and the variance value of the power consumption amount in the plurality of electrical equipments 71 contained in the same category are used as the reference electric energy.

The input unit 83 accepts input of the set information used in a predicting part 95, and sends the accepted set information to the predicting part 95. The set information indicates the instructed content and/or instructed period of the operation device 73.

The details of the control unit 80 and the storage unit 81 will now be described. As shown in FIG. 25, the control unit 80 has a configuration including the causal intensity calculating part (causal intensity calculating means) 90, a reference electric energy calculating part 91, a total electric energy waste detecting part (result abnormality determining means) 92, an individual electric energy waste detecting part 93, a visible image creating part (visible image creating means) 94, and the predicting part 95. The storage unit 81 stores the setting/environment history data (history information) 100, the electric energy history data (history information) 101, the causal structure data (causality information) 102, and the reference electric energy data 103.

The causal intensity calculating part 90 calculates the causal intensity between the variables in the causal structure data 102 using the setting/environment history data 100 and the electric energy history data 101. The method of calculating the causal intensity is similar to that described in the above embodiment. The causal intensity calculating part 90 adds the calculated causal intensity to the causal structure data 102 of the storage unit 81.

The reference electric energy calculating part 91 calculates the average value and the variance value of the power consumption amount of the electrical equipment 71 using the electric energy history data 101 of the storage unit 81 with respect to the electrical equipment 71 that is constantly operating. The reference power calculating part 91 stores the calculated average value and the variance value of the power consumption amount in the reference electric energy data 103 of the storage unit 81 as reference electric energy. The processing operation of the reference electric energy calculating part 91 may be performed only once immediately after the operation of the power supply system 70 or immediately after the change in setting of the device or performed constantly, but is desirably performed for every predetermined period from the aspect of accuracy and alleviating the processing load.

The total electric energy waste detecting part 92 uses the electric energy history data 101 and the reference electric energy data 103 of the storage unit 81 to detect whether or not the total power consumption amount in the target facility 72 is greater than the corresponding reference electric energy, thereby detecting waste. When detecting waste, the total electric energy waste detecting part 92 calculates that obtained by subtracting the reference electric energy from the total power consumption amount as degree of waste. The total electric energy waste detecting part 92 sends the notification that waste of the total power consumption amount is detected, and the degree of such waste to the visible image creating part 94.

When receiving the notification that waste of the total power consumption amount is detected from the total electric energy waste detecting part 92, the individual electric energy waste detecting part 93 uses the electric energy history data 101 and the reference electric energy data 103 of the storage unit 81 to detect whether or not the power consumption amount of each electrical equipment 71 is greater than the corresponding reference electric energy, thereby detecting waste. The individual electric energy waste detecting part 93 calculates that obtained by subtracting the reference electric energy from the power consumption amount as degree of waste with respect to the electrical equipment 71 from which waste is detected. The individual electric energy waste detecting part 93 sends information of the electrical equipment 71 from which waste is detected, and the degree of waste to the visible image creating part 94.

The power consumption amount of the electrical equipment 71 is assumed to change according to the period in one day such as morning, daytime, and night. The power consumption amount or the total power consumption amount are thus desirably for one or more days.

When a great number of electrical equipments 71 exist in the target facility 72, that obtained by subtracting the reference electric energy from the average value of the power consumption amount related to the plurality of electrical equipments 71 contained in the category based on the function and the location is assumed as the degree of waste.

The visible image creating part 94 reads out the causal structure data 102 from the storage unit 81, and creates the visible image of causal structure. When receiving notification that the waste of the total power consumption amount is detected from the total electric energy waste detecting part 92, the visible image creating part 94 receives information of the electrical equipment 71 from which waste is detected and the degree of the waste from the individual electric energy waste detecting part 93, and adds information such as color, character, and pattern indicating waste to the variable of the electrical equipment 71 from which waste is detected of the variables contained in the created visible image.

The visible image creating part 94 transmits the visible image added with information on the variable of the electrical equipment 71 from which waste is detected to the display unit 24. The visible image is then displayed on the display unit 24. The displayed visible image is similar to the visible image shown in FIG. 15 and the like, and thus the description thereof will be omitted.

The predicting part 95 predicts future time series data from the history data 100, 101 of the storage unit 81. The predicting part 95 stores the predicted time series data in the predicted time series data 105 of the storage unit 81.

A known time series prediction model may be used for the prediction of the predicting part 95. Examples of the time series prediction model include AR (Auto-Regressive) model, MA (Moving-Average) model, ARMA (Auto-Regressive Moving-Average) model, ARIMA (Auto-Regressive Integrated Moving-Average) model, SARMA (Seasonal Auto-Regressive Integrated Moving-Average) model, CARIMA (Controlled Auto-Regressive Integrated Moving-Average), and the like.

The predicting part 95 displays the graph based on the history data 100, 101 and the predicted time series data 105 on the display unit 84. FIG. 29 shows one example of a graph displayed on the display unit 84. FIG. 29A shows time series data of the outside temperature measured by the temperature sensor 76. FIG. 29B shows time series data of the power consumption amount of a certain electrical equipment 71 (equipment A), and time series data of the power consumption amount of another electrical equipment 71 (equipment B). In the figure, the solid line indicates the history data, and the broken line indicates the predicted time series data.

The predicting part 95 predicts the future time series from the electric energy history data 101 when the setting/ environment history data 100 of the storage unit 81 is changed to the set content indicated by the set information accepted by the input unit 83. The predicting part 95 stores the predicted time series data after the change in setting to the predicted time series data 105 of the storage unit 81. In the example of FIG. 29, the chain line in FIG. 29B shows the predicted time series data after the change in setting.

The predicting part 95 obtains the time series data of the reduced electric energy indicating the transition of reduced electric energy by subtracting the predicted time series data after the change in setting from the predicted time series data regarding the power consumption amount of the electrical equipment 71. The predicting part 95 stores the time series data of the reduced electric energy in the predicted time series data 105 of the storage unit 81.

FIG. 29C shows the predicted time series data of the reduced electric energy of equipment A and equipment B. In the figure, the upper part of the graph indicates the transition of the reduced electric energy of the equipment A, and the lower part of the graph indicates the transition of the reduced electric energy of the equipment B.

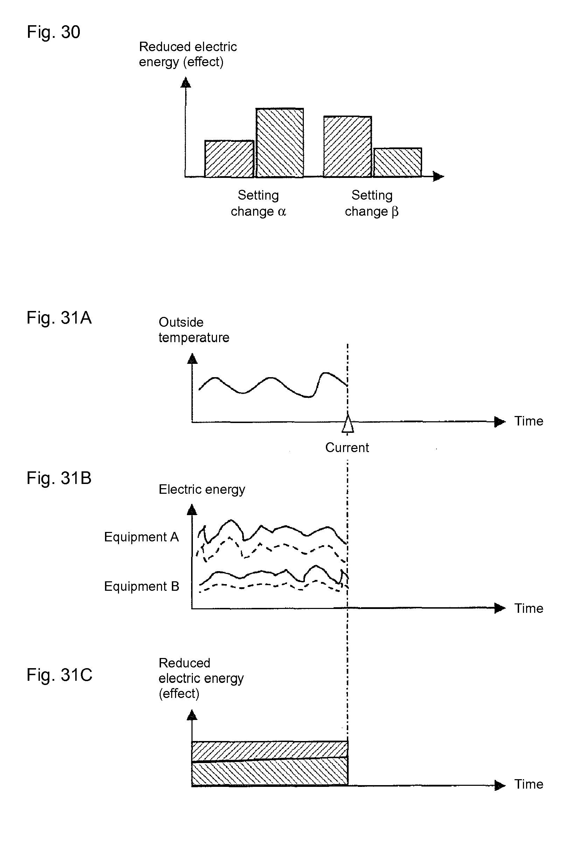

The predicting part 95 displays an integrated value graph of the reduced electric energy on the display unit 84 for every setting change based on the predicted time series data 105. FIG. 30 shows an example of a graph of the integrated value displayed on the display unit 84. In the figure, the integrated value of the reduced electric energy of equipment A and equipment B are shown in bar graph for each setting change $\alpha \cdot \beta$. For the bar graph of each setting change, the integrated value of the reduced electric energy of the equipment A is shown on the left side of the figure, and the integrated value of the reduced electric energy of the equipment B is shown on the right side of the figure.

The user can reference the graph of FIG. 30 to understand the extent of reduction of the power consumption amount of the electrical equipment 71 in any setting change. Thus, the user can easily carry out an accurate setting for reducing the power consumption amount. The graphs of FIGS. 29 and 30 are desirably displayed on the display unit 84 at the same time as or at the switch of the visible image created by the visible image creating part 94. In order to accurately reduce the power consumption amount by referencing the causality of the visible image, which setting to change can be easily recognized.

In the present embodiment, the predicting part 95 predicts the future time series data from the history data 100, 101 of the storage unit 81 to predict the future time series data after the setting change, but may predict the past time series data after the setting change. FIG. 31 corresponds to FIG. 29 and shows one example of a graph of the transition of the power consumption amount after the setting change going back to the past.

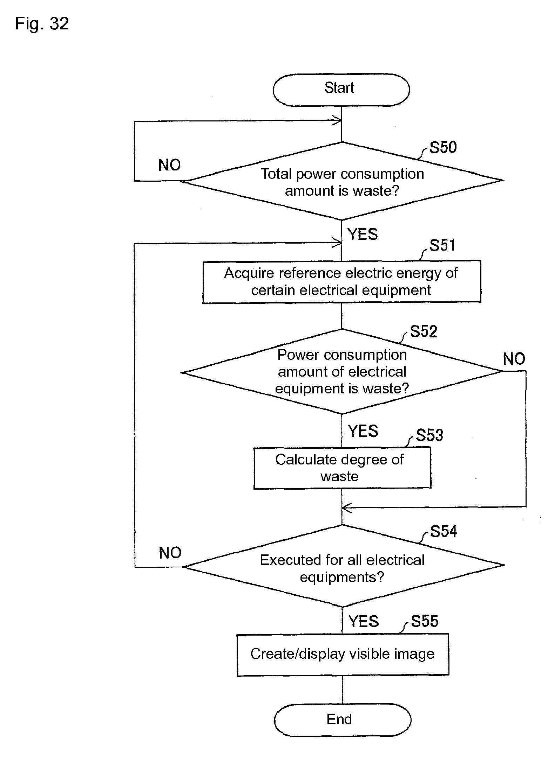

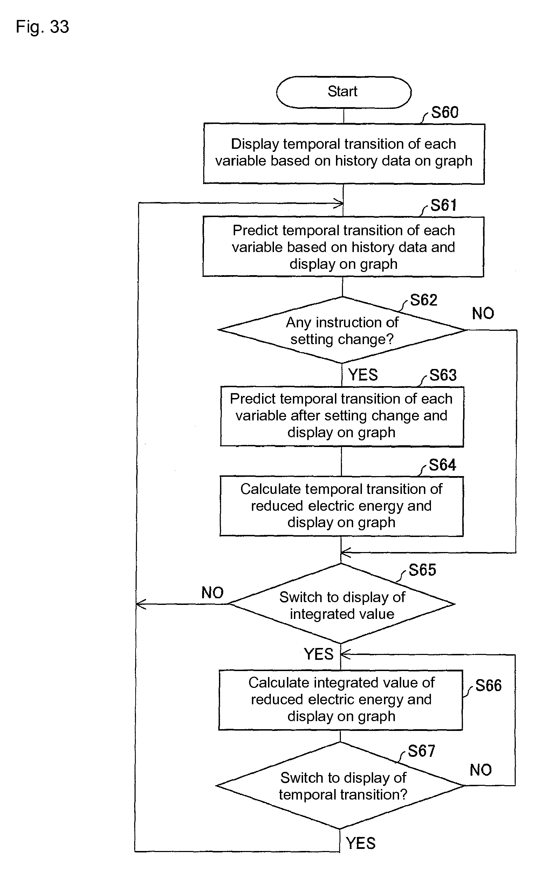

The processing operation in the control unit 80 of the factor estimating support device 77 having the above configuration will be described with reference to FIGS. 32 and 33. The processing operation of the causal intensity calculating part 30 of the control unit 80 is the same as the steps S10 and S11 of FIG. 16, and the description thereof will be omitted. The processing operation of the reference electric energy calculating part 91 of the control unit 80 is as described above, and the description thereof will be omitted.

FIG. 32 shows an outline of a processing operation of the total electric energy waste detecting part 92, the individual electric energy waste detecting part 93, and the visible image creating part 94 in the control unit 80. As shown in the figure, the process waits until the total electric energy waste detecting part 92 detects the waste of the total power consumption amount (S50). The determination of the waste of the total power consumption amount may be performed through the process similar to step S52 as hereinafter described.

When the waste is detected, the individual electric energy waste detecting part 93 acquires the reference electric energy contained in the reference electric energy data 103 of the storage unit 81 regarding the power consumption amount of a certain electrical equipment 71 (S51). The individual electric energy waste detecting part 93 then acquires the history data of the power consumption amount of the electrical equipment 71 from the electric energy history data 101 of the storage unit 81, and determines whether or not there is waste in the acquired power consumption amount (S52). This determination is made by determining whether or not the power consumption amount is greater than the reference electric energy during a predetermined period.

In step S52, if there is waste, the individual electric energy waste detecting part 93 calculates the degree of waste (S53). The degree of waste is obtained by integrating the difference between the power consumption amount of a predetermined period and the reference electric energy.

The individual electric energy waste detecting part 93 repeats the steps S51 to S53 for all the electrical equipments 71 (S54). The visible image creating part 94 creates the visible image using the information of the electrical equipment 71 determined to have waste by the individual electric energy waste detecting part 93, and the causal structure data 102 of the storage unit 81, and performs creating/displaying process of the visible image to be displayed on the display unit 84 (S55). The creating /displaying process of the visible image is similar to the process shown in FIG. 18, and thus the description thereof will be omitted. The processing operation in the total electric energy waste detecting part 92, the individual electric energy waste detecting part 93, and the visible image creating part 94 is thereafter terminated.

FIG. 33 shows an outline of a processing operation of the predicting part 95 in the control unit 80. As shown in the figure, the predicting part 95 first graphs the temporal transition of each variable based on the history data 100, 101 of the storage unit 81, and displays the same on the display unit 84 (S60). One example of the graph is shown with a solid line in FIGS. 29A, 29B.

The predicting part 95 predicts temporal transition of each variable based on the history data 100, 101 of the storage unit 81, graphs the predicted temporal transition, and displays the same on the display unit 84 (S61). One example of the graph is shown with a broken line in FIGS. 29A, 29B.

The predicting part 95 determines whether or not change of setting content is instructed from the input unit 83 (S62). If instruction is not made, the process proceeds to step S65. If instruction is made, the temporal transition of each variable after setting change (particularly, total power consumption amount and power consumption amount of each electrical equipment 71) based on the changed setting content and the history data 100, 101 of the storage unit 81, graphs the predicted temporal transition, and displays the same on the display unit 84 (S63). One example of the graph is shown with a chain dashed line in FIG. 29B.

The predicting part 95 then subtracts the temporal transition after the setting change from the temporal transition before the setting change regarding the power consumption amount of each electrical equipment 71 to calculate the temporal transition of the reduced electric energy, graphs the calculated temporal transition, and displays the same on the display unit 84 (S64). One example of the graph is shown with a chain dashed line in FIG. 29C.

In step S65, determination is made on whether or not an instruction to switch to display of integrated value is made from the input unit 83 (S65). If instruction is not made, the process returns to step S62 and repeats the operation.

If instruction is made, the integrated value of the reduced electric energy of each electrical equipment 71 is calculated, the calculated integrated value is graphed, and displayed on the display unit 84 (S66). If the setting change is performed over a plurality of times, the process of step S66 is performed for every setting change. One example of the graph is shown in FIG. 30.

Determination is then made on whether an instruction to switch to the display of the temporal transition is made from the input unit 83 (S67). If not instructed, the process returns to step S66 and repeats the operation. If instruction is made, the process returns to step S62 and repeats the operation.

The present invention is not limited to the embodiments described above, and various modifications can be made within the scope defined by the Claims. That is, embodiments obtained by combining the technical means appropriately changed within the scope defined by the Claims are also encompassed in the technical scope of the present invention.

In the embodiment, the cause of defective product is estimated by applying the present invention to the production step, but the present invention can be applied to cases of diagnosing disease from the causality of biological information such as blood pressure and body temperature.

Lastly, each block of the factor estimating support device 10, particularly, the control unit 20 may be configured by a hardware logic, or may be realized with software using the CPU as described below.

The factor estimating support device 10 includes a CPU (central processing unit) for executing the command of the control program for realizing each function, a ROM (read-only memory) for storing the program, a RAM (random access memory) for developing the program, a storage device (recording medium) such as memory for storing the programs and various data, and the like. The object of the present invention can be achieved by providing a recording medium in which a program code (execution program, intermediate code program, source program) of the control program of the factor estimating support device 10, which is software for realizing the above functions, are computer readably recorded to the factor estimating support device 10, and reading and executing the program code recorded on the recording medium by means of the computer (or CPU or MPU).

The recording medium may be tape such as magnetic tape or cassette tape; discs including magnetic disc such as floppy disc (registered trademark) disk/hard disc and optical disc such as CD-ROM/MO/MD/DVD/CD-R, cards such as IC card (including memory card)/optical card, or semiconductor memories such as mask ROM/EPROM/EEPROM/flash ROM.

The factor estimating support device 10 can be configured to be connectable with the communication network, and the program code may be provided via the communication network. The communication network is not particularly limited and may be Internet, intranet, extranet, LAN, ISDN, VAN, CATV communication network, virtual private network, telephone line network, mobile communication network, satellite communication network, and the like. A transmission medium configuring the communication network is not particularly limited and may be wired such as IEEE1394, USB, power line carrier, cable TV line, telephone line, ADSL line, or the like; or wireless such as infrared including IrDA and remote controller, Bluetooth (registered trademark), 802.11 wireless, HDR, portable telephone network, satellite line, digital terrestrial network, or the like. The present invention is also realized in a form of a computer data signal embedded in a carrier wave in which the program code is embodied in an electronic transmission.

Therefore, in the factor estimating support device according to the present invention, information notifying abnormality with respect to the variable determined as abnormal is added in the visible image in which the causality is visualized, and thus the user who references the visible image can easily understand how the abnormality is propagating along the causality, and can easily estimate the cause of abnormality.

According to the configuration and the method described above, when the variable corresponding to the result is determined as abnormal, determination is made whether or not each variable other than the variable corresponding to the result is abnormal. The variable determined as abnormal has a high possibility of including that which corresponds to the factor with respect to the result. Thus, in the present invention, information notifying abnormality with respect to the variable determined as abnormal is added in the visible image in which the causality is visualized. The visible image is output to the outside by an output means such as display means and printing means for the user to reference, so that the user can easily understand the variable that is abnormal, the user can easily understand how the abnormality is propagating along the causality, and the user can easily estimate the cause of abnormality.

Furthermore, in the factor estimating support device according to the present invention, a criterion setting means for setting the criterion that becomes a reference when the variable abnormality determining means determines abnormality based on the predetermined criterion that acts as a reference when the result abnormality determining means determines abnormality and the causality information is desirably arranged. The reference for determining abnormality can then be set even for the variables other than the variable corresponding to the result. Since the setting is performed based on the causality information, cases for when the causality is changed can also be responded.

Examples of the criterion include control criterion, target variance value, and the like in the production management.

Furthermore, in the factor estimating support device according to the present invention, a causal intensity calculating means for calculating the causal intensity indicating the intensity of the causality based on the history information is further arranged, where the criterion setting means desirably sets the criterion based on the causality information and the causal intensity. The criterion can be more appropriately set in view of the causal intensity.

Furthermore, the user can more accurately estimate the cause of abnormality since the user who references the visible image can also take causal intensity into consideration when estimating the factor of abnormality. Examples of change in causality information based on the causal intensity include changing the heaviness of the arrow indicating causality and adding numerical value of the causal intensity near the arrow.

The user can more accurately estimate the cause of abnormality since the user who references the visible image can also take degree of abnormality into consideration when estimating the factor of abnormality. Examples of change in causality information based on the degree of abnormality include changing the dimension of the vertex indicating a variable.

Furthermore, the variables are organized and arranged by type in the visible image, and thus are more easy to see to users who reference the visible image, and the user can more easily estimate the cause of abnormality.

When abnormality of the product, that is, defective product is generated, the abnormality of various variables in the production system is determined and reflected on the visible image in which the causality is visualized, so that the user who references the visible image can easily estimate the cause the defective product was produced.

If the total value of the power consumption amount in the power supply system is in a waste state, the waste state of the power consumption amount of various electrical equipments in the power supply system is determined and reflected on the visible image in which the causality is visualized. The user who references the visible image then can easily estimate the cause there is waste in power consumption amount.

When a value of the variable other than the power consumption amount is changed, prediction can be made on whether the power consumption amount or the total value thereof will be the waste state. Therefore, the user can easily estimate how to change the value of the variable to resolve the waste state.

Each step in the factor estimating support device can be executed by a computer by the factor estimating support program. The factor estimating support program can be stored in a computer readable recording medium, so that the factor estimating support program can be executed on an arbitrary computer.

The factor estimating support device according to the present invention adds information of the abnormal variable to the visible image in which the causality is visualized so that the cause of abnormality can be easily estimated, and thus can be applied to an arbitrary system having causality such as simulation system for saving energy and diagnosis system for disease.

**Claims**

1. A factor estimating support device (10) for supporting estimation of factor from a result generated in a system to be diagnosed (1); the factor estimating support device (10) comprising:

   a variable history storage unit (21) for storing history information (40, 41) of a plurality of variables acquired from the system (1);
   a causality storage unit (21) for storing causality information (42) indicating a causality between the plurality of variables;
   a result abnormality determining means (32) for determining whether a variable corresponding to the result is abnormal;
   a variable abnormality determining means (33) for determining whether each variable other than the variable corresponding to the result is abnormal when the result abnormality determining means (32) determines as abnormal; and
   a visible image creating means (34) for creating a visible image (50) in which the causality is visualized using the causality information (42), the visible image creating means (34) adding information notifying abnormality with respect to a variable determined as abnormal by the result abnormality determining means (32) and the variable abnormality determining means (33) in the visible image (50).

2. A factor estimating device (10) according to claim 1, further comprising a criterion setting means (31) for setting a criterion that becomes a reference when the variable abnormality determining means (33) determines abnormality based on a predetermined criterion that becomes a reference when the result abnormality determining means (32) determines as abnormal and the causality information (42).

3. A factor estimating device (10) according to claim 2, further comprising a causal intensity calculating means (30) for calculating a causal intensity indicating intensity of the causality based on the history information (40, 41); **characterized in that** the criterion setting means (31) sets the criterion based on the causality information (42) and the causal intensity.

4. A factor estimating device (10) according to claim 1, further comprising a causal intensity calculating means (30) for calculating a causal intensity indicating intensity of the causality based on the history information (40, 41);

**characterized in that**
the visible image creating means (34) changes the causality information (42) in the visible image (50) based on the causal intensity.

5. A factor estimating device (10) according to claim 1, **characterized in that**
the variable abnormality determining means (33) calculates a degree of abnormality regarding the variable determined as abnormal; and
the visible image creating means (34) changes the causality information (42) in the visible image (50) based on the degree of abnormality.

6. A factor estimating device (10) according to claim 1, **characterized in that**
the plurality of variables are categorized into a plurality of types; and
the visible image (50) created by the visible image creating means (34) is divided into a plurality of regions corresponding to the plurality of types, the information of the variable being arranged in the region corresponding to the type to which the variable belongs.

7. A factor estimating device (10) according to claim 1, **characterized in that** the system to be diagnosed (1) is a production system for manufacturing products through a plurality of steps.

8. A factor estimating device (77) according to claim 1, **characterized in that**

the system to be diagnosed (1) is a power supply system (70) for supplying power to a plurality of electrical equipments (71);
the plurality of variables include a power consumption amount of the plurality of electrical equipments (71);
the variable corresponding to the result is a total value of the power consumption amount in the power supply system (70); and
the abnormality is a waste state of when the power consumption amount is greater than a reference electric energy.

9. A factor estimating device (77) according to claim 8, further comprising:

an input means (83) for inputting a value of a variable other than the power consumption amount;
a predicting means (95) for predicting time series information of the power consumption amount when changed to the value of the variable input by the input means (83) based on history information stored in the variable history storage unit (33); and
a predicted time series data storage unit (81) for storing time series information (105) predicted by the predicting means (95); **characterized in that**
the result abnormality determining means (32) further determines whether the variable corresponding to the result is abnormal based on the time series information (105) corresponding to the variable; and
the variable abnormality determining means (33) further determines whether each variable other than the variable corresponding to the result is abnormal based on the time series information corresponding to the variable when the result abnormally determining means (32) determines as abnormal.

10. A method of controlling a factor estimating support device (10) for supporting estimation of factor from a result generated in a system to be diagnosed (1); the factor estimating support device (10) including a variable history storage unit (21) for storing history information (40, 41) of a plurality of variables acquired from the system (1), and a causality storage unit (21) for storing causality information (42) indicating a causality between the plurality of variables; the method comprising:

a result abnormality determining step for determining whether a variable corresponding to the result is abnormal;
a variable abnormality determining step for determining whether each variable other than the variable corresponding to the result is abnormal when determined abnormal in the result abnormality determining step; and
a visible image creating step for creating a visible image (50) in which the causality is visualized using the causality information (42), the visible image creating step adding information notifying abnormality with respect to a variable determined as abnormal in the result abnormality determining step and the variable abnormality determining step in the visible image (50).

11. A factor estimating support program for operating a factor estimating support device (10) for supporting estimation of factor from a result generated in a system to be diagnosed (1); the factor estimating support device (10) including a variable history storage unit (21) for storing history information (40, 41) of a plurality of variables acquired from the system (1), and a causality storage unit (21) for storing causality information (42) indicating a causality between the plurality of variables; the program causing a computer to execute:

a result abnormality determining step for determining whether a variable corresponding to the result is abnormal; a variable abnormality determining step for determining whether each variable other than the variable corresponding to the result is abnormal when determined abnormal in the result abnormality determining step; and a visible image creating step for creating a visible image (50) in which the causality is visualized using the causality information (42), the visible image creating step adding information notifying abnormality with respect to a variable determined as abnormal in the result abnormality determining step and the variable abnormality determining step in the visible image (50).

Fig. 1

EP 1 967 996 A1

Fig. 2

EP 1 967 996 A1

Fig. 3

Fig. 4

| A | B | C | ... |
|---|---|---|-----|
| 3 | 22 | 2 | ... |
| 10 | 54 | 1 | ... |
| 5 | 11 | 1 | ... |
| 1 | 61 | 2 | ... |
| 3 | 66 | 1 | ... |
| . | . | . | |

Fig. 5

Fig. 6

Variable D
(final quality characteristic)

Variable A

Variable B

Variable C

Fig. 7

Fig. 8

Fig. 9

EP 1 967 996 A1

40,41

| ID | Squeegee pressing amount | Temperature inside printing device | Humidity inside printing device | P offset value_land distal end direction | Back fillet length | Print misalignment _land distal end direction | Printing area | Mounting misalignment amount_land distal end direction |
|---|---|---|---|---|---|---|---|---|
| 0001 | 1.1491254 | 0.3909726 | −1.2945769 | 0.1229243 | 4.3262472 | 1.7653172 | 0.3861274 | 0.4291460 |
| 0002 | 1.9434932 | 2.0335637 | −2.3561493 | −0.2063588 | −2.8151910 | −1.7198347 | 0.3238132 | −0.0795167 |
| 0003 | 1.0185049 | −0.2214781 | −1.9407506 | 0.5889361 | 4.6322834 | −0.1229867 | 0.1711992 | −0.2130516 |
| 0004 | 2.4487411 | 2.1648436 | 1.7768328 | 1.7519730 | −0.4079410 | 0.2768154 | 1.5690352 | 0.0017974 |
| 0005 | 0.3705024 | 0.4579984 | −3.0905531 | 3.6626376 | −2.1288162 | −3.0490240 | −0.2712316 | 0.3426270 |
| 0006 | 1.6951981 | 0.4309000 | −2.2312438 | 1.8082115 | −2.1955137 | −3.0335752 | −0.0058593 | 0.1679086 |
| 0007 | 4.3156336 | 0.3122826 | −0.4440276 | −0.6713913 | 0.6829714 | 0.8456969 | 0.9030544 | 0.6011441 |
| 0008 | 2.0630034 | 4.7219326 | −2.4396383 | 0.6902474 | −2.4463277 | −1.4120717 | 1.4605437 | 0.0829731 |
| 0009 | 1.7859043 | 1.2517711 | −4.7129821 | 2.6202672 | −1.8357812 | −2.9067698 | 1.2476596 | −0.2687188 |
| 0010 | 1.4070116 | 1.0521817 | −0.5198506 | 1.1693864 | −1.0562049 | −1.1112377 | 0.3535011 | 0.1630157 |
| 0011 | 2.8370553 | 3.4405733 | −4.1098321 | −0.7782234 | −1.9940045 | −2.1119849 | 1.0981024 | −0.3025229 |
| 0012 | 2.6181080 | 0.8651763 | 0.5831620 | 0.7528693 | 2.1690236 | −1.9968631 | 0.1145527 | 0.4578368 |
| 0013 | 2.9228181 | 3.7642218 | −2.8627152 | 0.7833932 | −2.2400825 | −0.8719896 | 1.5052132 | 0.3112456 |
| 0014 | 1.1651637 | 4.9152345 | −0.9971128 | 4.1929761 | −0.5386840 | −0.9737116 | 1.8410810 | −0.3495446 |
| 0015 | 1.8982512 | −0.6622848 | −5.3440583 | 0.0954570 | −0.4027892 | −3.4096141 | 0.2300381 | −0.1826520 |
| 0016 | 2.3624964 | 0.9097592 | 3.1799851 | −0.4282650 | −2.7888570 | −0.3988847 | 1.3591517 | −0.0451434 |
| 0017 | 2.7089320 | 1.0450128 | 1.7546794 | 0.9512682 | 1.5471057 | 0.5741799 | 0.9756625 | −0.0953621 |
| 0018 | 0.9761825 | 2.7466165 | −5.2178123 | −1.5054419 | 0.2021972 | −1.9797670 | −1.1535217 | −0.3191887 |
| 0019 | 2.4772493 | 0.6104531 | −6.0793061 | 2.3879524 | 2.2466952 | −1.4505652 | −0.3061767 | −0.4491918 |

Fig. 10

Fig. 11

42

| Starting point | End point |
|---|---|
| Squeegee pressing amount | Printing area |
| Temperature inside printing device | Printing area |
| Humidity inside printing device | Printing area |
| P offset value_land distal end direction | Print misalignment_land distal end direction |
| Back fillet length | Fillet length |
| Print misalignment_land distal end direction | Mounting misalignment amount_land distal end direction |
| Printing area | Fillet length |
| Mounting misalignment amount_land distal end direction | Fillet length |
| Land position_X coordinate | Printing area |
| Land position_X coordinate | Print misalignment_land distal end direction |
| Land position_X coordinate | Fillet length |
| Heating temperature | Fillet length |
| Z offset value_land distal end direction | Z part misalignment_land distal end direction |
| Z offset value_land distal end direction | Mounting misalignment amount_land distal end direction |
| Z part misalignment_land distal end direction | Mounting misalignment amount_land distal end direction |

Fig. 12

$\overset{44}{\frown}$

| Variable name | Lower limit | Upper limit | Target average value | Target variance value |
|---|---|---|---|---|
| Squeegee pressing amount | −1.675179198 | 6.016000428 | 2.170410615 | 0.977 |
| Temperature inside printing device | −1.634012431 | 4.885950985 | 1.625969277 | 0.7021 |
| Humidity inside printing device | −4.931017167 | 2.224711059 | −1.353153054 | 0.8457 |
| P offset value_land distal end direction | −12.53556603 | 13.17356407 | 0.31899902 | 10.9165 |
| Back fillet length | −5.234466812 | 5.634150744 | 0.199841966 | 1.951 |
| Print misalignment_land distal end direction | −41.14777619 | 37.76317233 | −1.692301932 | 102.845 |
| Printing area | −7.481779314 | 9.748404288 | 1.133312487 | 4.9033 |
| Mounting misalignment amount_land distal end direction | −7.546998008 | 7.535658108 | −0.00566995 | 3.7572 |
| Land position_X coordinate | −3.444837079 | 3.425115387 | −0.009860846 | 0.7795 |
| Heating temperature | −20.90151582 | 19.37368393 | −0.763915948 | 26.7907 |
| Z offset value_land distal end direction | −30.36233059 | 30.97131731 | 0.30449336 | 62.1307 |
| Z part misalignment_land distal end direction | −14.09012538 | 11.41625795 | −1.336933713 | 10.745 |

Fig. 13

$-3.891 \times \sigma$   $+3.891 \times \sigma$

Fig. 14

Fig. 15

EP 1 967 996 A1

Fig. 16

```
        ┌─────────────┐
        │    Start    │
        └──────┬──────┘
               │         ⌐S10
        ┌──────┴──────────────┐
        │ Calculate causal     │
        │ intensity by         │
        │ regression analysis  │
        └──────┬──────────────┘
               │         ⌐S11
        ┌──────┴──────────────┐
        │ Acquire linear       │
        │ structural equation  │
        └──────┬──────────────┘
               │         ⌐S12
        ┌──────┴──────────────────┐
        │ Calculate variance target │
        │ value of final quality    │
        │ characteristic            │
        └──────┬──────────────────┘
               │         ⌐S13
        ┌──────┴──────────────┐
        │ Calculate variance   │
        │ target value of      │
        │ other variables      │
        └──────┬──────────────┘
               │         ⌐S14
        ┌──────┴──────────────────┐
        │ Calculate variable       │
        │ control criterion        │
        └──────┬──────────────────┘
               │
        ┌──────┴──────┐
        │    End      │
        └─────────────┘
```

Fig. 17

```
                    ┌─────────────┐
                    │    Start    │
                    └──────┬──────┘
                           │
         ┌─────────────────▼──────────────┐
         │                                 │  ┌S20
  NO     ◇      Final quality characteristic
  ┌──────◇           abnormal?            ◇
  │      └──────────────┬─────────────────┘
  │                     │ YES      ┌S21
  │      ┌──────────────▼─────────────────────┐
  │      │ Acquire target vale and control     │
  │      │    criterion of certain variable    │
  │      └──────────────┬─────────────────────┘
  │                     │              ┌S22
  │      ◇──────────────▼──────────────◇  NO
  │      ◇   Average of variable abnormal?    ◇───┐
  │      └──────────────┬─────────────────┘       │
  │                     │ YES    ┌S23             │
  │      ┌──────────────▼─────────────────────┐   │
  │      │ Calculate degree of abnormality    │   │
  │      │          of average                │   │
  │      └──────────────┬─────────────────────┘   │
  │                     │◄──────────────────────────┘
  │                     │              ┌S24
  │      ◇──────────────▼──────────────◇  NO
  │      ◇  Variance of variable abnormal?    ◇───┐
  │      └──────────────┬─────────────────┘       │
  │                     │ YES    ┌S25             │
  │      ┌──────────────▼─────────────────────┐   │
  │      │ Calculate degree of abnormality    │   │
  │      │          of variance               │   │
  │      └──────────────┬─────────────────────┘   │
  │                     │       ┌S26              │
  │      ┌──────────────▼─────────────────────┐   │
  │      │ Calculate degree of abnormality     │   │
  │      │ taking average and variance into    │   │
  │      │          consideration              │   │
  │      └──────────────┬─────────────────────┘   │
  │                     │◄──────────────────────────┘
  │   NO                │              ┌S27
  └──────◇──────────────▼──────────────◇
         ◇    Executed for all variables?    ◇
         └──────────────┬─────────────────┘
                        │ YES    ┌S28
                 ┌──────▼──────┐
                 │  Create and │
                 │    display  │
                 │ visible image│
                 └──────┬──────┘
                        │
                 ┌──────▼──────┐
                 │     End     │
                 └─────────────┘
```

Fig. 18

```
        ( Creation/display of visible image )
                         |
                         |                    S30
   +-------------------------------------------------+
   | Highlight vertex of final quality characteristic from which |
   | abnormality is detected with respect to visible image of |
   |                    causality                    |
   +-------------------------------------------------+
                         |
         +------------------------>
         |               |                    S31
         |    +-------------------------------------------+
         |    | Further highlight variable which degree of abnormality is |
         |    | largest out of variables that become factor of variable |
         |    | corresponding to previously highlighted vertex, and |
         |    | highlight arrow between relevant vertex and previously |
         |    |            highlighted vertex             |
         |    +-------------------------------------------+
         |                 |
         |                 |                  S32
         |   YES  <  Variable that becomes further  >
         +--------<        factor exist?            >
                         |
                        NO              S33
            +-------------------------------------+
            |     Display created visible image   |
            +-------------------------------------+
                         |
                    ( Return )
```

EP 1 967 996 A1

Fig. 19A

Fig. 19B

Fig. 19C

36

Fig. 20

( Creation/display of visible image )

S35

Highlight vertex of final quality characteristic from which abnormality is detected with respect to visible image of causality

S36

Highlight arrow having previously highlighted vertex as ending point

S37

NO — One of vertices that becomes ending point of arrow highlighted in previous step specified by user?

YES

S38

Change to visible image in which specified vertex is highlighted

S39

YES — Variable that becomes further factor exists?

NO

( Return )

Fig. 21A

Fig. 21B

Fig. 21C

Fig. 22

Creation/display of visible image

S40
Add information of final quality characteristic from which abnormality is detected as abnormal variable of final step

S41
Add information of variable which degree of abnormality is largest of variables contained in immediately preceding step of step including previously added abnormal variable as abnormal variable of immediately preceding step

S42
Step on upstream side of step including abnormal variable added in previous step exists?

YES

NO

S43
Display created abnormality notifying image

Return

Fig. 23A

| | | |
|---|---|---|
| Reflow step abnormality | Fillet length | |
| Mounting step abnormality | | |
| Printing step abnormality | | |

60

Fig. 23B

| | | |
|---|---|---|
| Reflow step abnormality | Fillet length | |
| Mounting step abnormality | Mounting misalignment | |
| Printing step abnormality | | |

60

Fig. 23C

| | | |
|---|---|---|
| Reflow step abnormality | Fillet length | |
| Mounting step abnormality | Mounting misalignment | |
| Printing step abnormality | Printing volume | |

60

Fig. 24

Fig. 25

Fig. 26

| Measurement date and time | Air conditioner | Set temperature | Illuminator | Switch | Outside temperature |
|---|---|---|---|---|---|
| 2007/6/24 0:00 | 419 | 24 | 0 | 0 | 25.6 |
| 2007/6/24 0:10 | 467 | 24 | 0 | 0 | 25.8 |
| 2007/6/24 0:20 | 304 | 24 | 0 | 0 | 25.8 |
| 2007/6/24 0:30 | 594 | 24 | 100 | 1 | 25.8 |
| 2007/6/24 0:40 | 406 | 24 | 100 | 1 | 25.8 |
| 2007/6/24 0:50 | 411 | 24 | 100 | 1 | 25.8 |
| 2007/6/24 1:00 | 425 | 23 | 100 | 1 | 25.8 |
| 2007/6/24 1:10 | 407 | 23 | 100 | 1 | 25.9 |
| 2007/6/24 1:20 | 402 | 23 | 0 | 0 | 25.8 |
| 2007/6/24 1:30 | 446 | 23 | 0 | 0 | 25.8 |
| 2007/6/24 1:40 | 380 | 23 | 0 | 0 | 25.8 |
| 2007/6/24 1:50 | 468 | 23 | 0 | 0 | 26.0 |

Fig. 27

Fig. 28

| ID | Name | Child ID |
|----|------|----------|
| 1 | Air conditioner | 6 |
| 2 | Set temperature | 1,3 |
| 3 | Illuminator | 6 |
| 4 | Switch | 3 |
| 5 | Outside temperature | 1,3 |
| 6 | Target facility | NULL |

Fig. 29A

Outside temperature

Current

Time

Fig. 29B

Electric energy

Equipment A

Equipment B

Time

Fig. 29C

Reduced electric energy (effect)

Time

Fig. 30

Fig. 31A

Fig. 31B

Fig. 31C

Fig. 32

Start

S50
Total power consumption amount is waste?
NO

YES
S51
Acquire reference electric energy of certain electrical equipment

S52
Power consumption amount of electrical equipment is waste?
NO

YES
S53
Calculate degree of waste

S54
Executed for all electrical equipments?
NO

YES
S55
Create/display visible image

End

Fig. 33

```
                    ( Start )
                              ┌─ S60
    ┌──────────────────────────────────┐
    │ Display temporal transition of each │
    │ variable based on history data on graph │
    └──────────────────────────────────┘
                              ┌─ S61
    ┌──────────────────────────────────┐
    │ Predict temporal transition of each │
    │ variable based on history data and │
    │        display on graph          │
    └──────────────────────────────────┘
                              ┌─ S62        NO
         < Any instruction of setting change? >
                   YES        ┌─ S63
    ┌──────────────────────────────────┐
    │ Predict temporal transition of each │
    │ variable after setting change and │
    │        display on graph          │
    └──────────────────────────────────┘
                              ┌─ S64
    ┌──────────────────────────────────┐
    │ Calculate temporal transition of │
    │   reduced electric energy and    │
    │        display on graph          │
    └──────────────────────────────────┘
                              ┌─ S65
    NO   < Switch to display of integrated value >
                   YES
    ┌──────────────────────────────────┐
    │ Calculate integrated value of    │  ┌─ S66
    │   reduced electric energy and    │
    │        display on graph          │
    └──────────────────────────────────┘
                              ┌─ S67        NO
         < Switch to display of temporal transition? >
                   YES
```

**European Patent Office**

**EUROPEAN SEARCH REPORT**

Application Number

EP 08 15 2399

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| L | The technical aspects identified in the present application (Art. 92 EPC) are considered part of common general knowledge. Due to their notoriety no documentary evidence is found to be required. For further details see the accompanying Opinion and the reference below. XP002456252 ----- | 1-11 | INV. G06Q10/00 |

TECHNICAL FIELDS SEARCHED (IPC)

G06Q

The present search report has been drawn up for all claims

| Place of search | Date of completion of the search | Examiner |
|---|---|---|
| The Hague | 11 July 2008 | Thiam, Mansour |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006065598 A
- JP 2006173373 A